# EUROPEAN PATENT SPECIFICATION

(11) **EP 2 149 072 B1**
(45) Date of publication and mention of the grant of the patent: **03.11.2010**
(21) Application number: 08759565.8
(22) Date of filing: 14.05.2008
(51) Int. Cl.: G03F 7/32

(54) **A GUM SOLUTION FOR DEVELOPING AND GUMMING A PHOTOPOLYMER PRINTING PLATE**
GUMMILÖSUNG ZUM ENTWICKELN UND GUMMIEREN EINER PHOTOPOLYMERDRUCKPLATTE
SOLUTION DE GOMME DESTINÉE AU DÉVELOPPEMENT ET AU GOMMAGE D'UNE PLAQUE D'IMPRESSION PHOTOPOLYMÈRE

(30) Priority: 15.05.2007 EP 07108228; 15.05.2007 US 938015 P
(43) Date of publication of application: 03.02.2010
(73) Proprietor: Agfa Graphics N.V., 2640 Mortsel (BE)
(72) Inventor: GRIES, Willi-Kurt, D-55252 Mainz-kastel (DE); HENDRIKX, Peter, B-2640 Mortsel (BE); VAN DAMME, Marc, B-2640 Mortsel (BE)
(74) Representative: Goedeweeck, Rudi
(86) International application number: PCT/EP2008/055872
(87) International publication number: WO 2008/138942

(56) References cited:
- EP-A- 1 103 859
- EP-A- 1 602 982
- EP-A- 1 621 339
- EP-A- 1 650 605
- EP-A- 1 755 002
- WO-A-2005/111727

## Description

### FIELD OF THE INVENTION

The present invention related to a gum solution which can be used for developing and gumming a lithographic printing plate precursor. The present invention relates also to a method for preparing a lithographic printing plate.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called "driographic" printing, the lithographic image consists of ink-accepting and ink-abhesive (ink-repelling) areas and during driographic printing, only ink is supplied to the master.

Printing masters are generally obtained by the so-called computer-to-film (CtF) method, wherein various pre-press steps such as typeface selection, scanning, color separation, screening, trapping, layout and imposition are accomplished digitally and each color selection is transferred to graphic arts film using an imagesetter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a printing plate precursor by means of a so-called plate-setter. A printing plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Photopolymers can be sensitized for blue, green or red light (i.e. wavelength range between 450 and 750 nm), for violet light (i.e. wavelength range between 350 and 450 nm) or for infrared light(i.e. wavelength range between 750 and 1500 nm). Laser sources have been increasingly used to expose a printing plate precursor which is sensitized to a corresponding laser wavelength. Typically, an Ar laser (488 nm) or a FD-YAG laser (532 nm) can be used for exposing a visible light sensitized photopolymer plate. The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material. An infrared laser diode emitting around 830 nm or a Nd-YAG laser emitting around 1060 nm can also be used.

Typically, a photopolymer plate precursor comprises a support, a photopolymerizable coating and an overcoat. The photopolymerizable coating comprises a polymerizable compound, a polymerization initiator and a binder, and the overcoat comprises usually a polyvinylalcohol binder to hinder the penetration of oxygen in the coating. Upon image-wise exposure, free radicals formed by the initiator are not quenched by the oxygen and can initiate crosslinking and/or polymerization of the polymerizable compound, resulting in hardening or curing of the exposed areas. The exposed precursor is usually processed in alkaline developer having a pH > 10, whereby the overcoat and the photopolymerizable coating at the non-exposed areas are solubilized in the developer solution. US2004/0131974 discloses a method for making such a lithographic printing plate whereby, after image-wise exposure, the overcoat is removed with water in a prewashing step, resulting in a reduction of the formation of sludge in the alkaline developing solution and whereby staining is prevented at the non-image portions.

Currently, most commercial lithographic plates require an additional gumming process after the exposed plates is developed and before it is put on the press, in order to protect the plate from contamination, e.g. by oxidation, fingerprints, fats, oil or dust, or from damaging, e.g. by scratches during handling of the plate. Such an additional gumming step is not convenient for the end-user, because it is a time consuming step and requires an additional gumming station.

WO 02/101 469 discloses a method of processing an imageable element useful as alkaline-developable lithographic printing plate precursor wherein the element is developed and gummed with an aqueous alkaline developing-gumming solution comprising a water-soluble polyhydroxy compound having a specific structure.

EP 1 342 568 discloses a method for making a heat-sensitive lithographic printing plate wherein the image-wise heated precursor, comprising a coating of hydrophobic thermoplastic polymer particles which coalescence on heating, is developed with a gum solution. A practical embodiment for this type of printing plates was introduced by Agfa under the tradename Azura.

WO 2005/111727 discloses a method for making a lithographic printing plate wherein the image-wise exposed precursor, comprising a photopolymerisable coating, is developed with a gumming solution.

In WO 2006/026229, EP 1 602 982, EP 1 621 339, EP 1 630 618, EP 1 705 522, EP 1 755 002 and US 2007/0020563, a method is disclosed wherein an image-wise exposed photopolymer printing plate precursor is developed with an aqueous solution.

In WO 2007/057333, WO 2007/057334, WO 2007/057335, WO 2007/057336, WO 2007/057337, WO 2007/057346, WO 2007/057347, WO 2007/057348, WO 2007/057349 and WO 2007/057442 a method for making a lithographic printing plate is disclosed wherein the image-wise exposed precursor is developed with a gumming solution.

It is important for the customer that the printing plates exhibit a high printing quality during the printing process and that no toning appears during the printing process. This means that the hydrophilic non-printing areas, formed by the hydrophilic surface of the support, do not exhibit a tendency to acceptant ink but only fountain solution. Therefore, it is important that the clean-out, i.e. removal of the coating at the non-exposed areas, is improved.

### SUMMARY OF THE INVENTION

It is an object of the present invention to provide a gum solution which is suitable for developing and gumming a lithographic printing plate precursor and wherein the obtained printing plates exhibit an improved clean-out. This object is realized by the gum solution as defined in claim 1, having the specific feature that it comprises a salt formed by reaction of an acid, selected from phosphoric acid and phosphorous acid, with a di- or tri-alkanolamine.

It is also an object of the present invention to provide a method for preparing a lithographic printing plate, having the specific feature that the image-wise exposed precursor is developed and gummed with that gum solution. The printing plates obtained by this method exhibit an improved clean-out and no toning during the printing process. This means that the coating at the non-exposed area is sufficiently removed from the support such that there is no tendency of accepting ink on these areas during the printing process.

Other specific embodiments of the invention are defined in the dependent claims.

### DETAILED DESCRIPTION OF THE INVENTION

In accordance with the present invention, there is provided a gum solution, suitable for developing and gumming a lithographic printing plate precursor, comprising a film-forming hydrophilic polymer or surfactant, and a salt formed by reaction of an acid, selected from phosphoric acid and phosphorous acid, with a di- or tri-alkanolamine. In a more preferred embodiment of the present invention, said acid is phosphoric acid.

Said phosphoric acid and phosphorous acid include also special forms of phosphoric acid and phosphorous acid such as orthophosphoric acid, meta-phosphoric acid, ortho-phosphorous acid, meta-phosphorous acid. It is also possible that said phosphoric acid and phosphorous acid are presents as mono or di salts, but a trivalent phosphoric acid and phosphorous acid are preferred.

In another embodiment of the present invention, said alkanol group of said di- or tri-alkanolamine is an alkyl group substituted by at least one hydroxyl group. The alkyl group may be further substituted by other groups such as another hydroxyl group, a halogen, a nitro group, a nitrile group, an (hetero)aromatic group or a saturated or unsaturated hydrocarbon group. The alkyl group may have a linear, branched or cyclic structure. The alkyl group has preferably a linear or branched structure.

The alkyl group comprises preferably at most 15 carbon atoms, more preferably at most 12 carbon atoms, most preferably at most 8 carbon atoms.

Examples of such an alkanol group are:
HO-CH₂-*, HO-CH₂-CH₂-*, HO-CH₂-CH₂-CH₂-*, CH₃-CH(OH)-CH₂-*, CH₃-C(OH)(CH₃)-*, HO-CH₂-CH₂-CH₂-CH₂-*, CH₃-CH(CH₃)-CH(OH)-*, CH₃-CH(C₂H₅)-CH(OH)-*, CH₃-C(CH₃)(OH)-CH₂-*, HO-CH₂-CH₂-CH₂-CH₂-CH₂-CH₂-*, HO-CH₂-CH₂-CH₂-CH(OH)-CH₂-CH₂-*, CH₃-CH₂-CH(OH)-CH₂-CH₂-CH₂-*, CH₃-CH(CH₃₎-CH₂-CH(OH)-CH₂-*, CH₃-CH(C₂H₅)-CH₂-CH(OH)-CH₂-*, HO-CH₂-CH₂-CH₂-CH₂-CH₂-CH₂-CH₂-CH₂-*, HO-CH₂-CH₂-CH₂-CH(OH)-CH₂-CH₂-CH₂-CH₂-*, CH₃-CH₂-CH(OH)-CH₂-CH₂-CH₂-CH₂-CH₂-*, CH₃-CH(CH₃)-CH₂-CH(OH)-CH₂-CH₂-CH₂-* and CH₃-CH(CH₃)-CH₂-C(C₂H₅)(OH)-CH₂-CH₂-CH₂-*, wherein * indicates the binding site to the N of the amine group.

Examples of di- or tri-alkanolamines according to the present invention are:
Amine-01: triethanolamine
Amine-02: diethanolamine
Amine-03: 2-amino-2-methyl-1,3-propanediol
Amine-04: 2-amino-2-ethyl-1,3-propanediol
Amine-05: tri(hydroxymethyl)-amino-methane
Amine-06: tri(isopropanol)-amine

The salt in the gum solution of the present invention is formed by reaction of an acid, selected from phosphoric acid and phosphorous acid, with a di or tri alkanolamine. The salt is preferably present in the gum solution in a concentration of at least 0.02 mol/l, more preferably at least 0.1 mol/l, most preferably at least 0.15 mol/l. The salt is preferably present in the gum solution in a concentration of at most 5 mol/l, more preferably at most 2.5 mol/l, most preferably at most 1 mol/l. The ratio of the amount in mole of the amine to the amount in mole of the acid is preferably at least 0.1, more preferably at least 0.4, most preferably at least 0.75. The ratio of the amount in mole of the amine to the amount in mole of the acid is preferably at most 20, more preferably at most 12, most preferably at most 5.

The salt of the present invention may be formed by reaction of a trivalent phosphoric acid or phosphorous acid with a monovalent amine substituted with two or three alkanol groups. The acid in the salt is at least partially neutralized by the amine.

The ratio of the amount of equivalent base functions of the amine to the amount of equivalent acid functions of the acid is preferably at least 0.03, more preferably at least 0.15, most preferably at least 0.45. The ratio of the amount of equivalent base to the amount of equivalent acid is preferably at most 12, more preferably at most 7, most preferably at most 3.

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². This layer of surface protective compound remaining on the plate has the advantage that, before mounting the plate on the press and starting the printing process, the plate needs no additional step of rinsing, because, by rinsing the plate, this layer of surface protective compound will be removed, resulting in the necessity of an additional gumming step to protect the plate again.

In the present description, all concentrations of compounds present in the gum solution are expressed as percentage by weight (wt.% or % w/w) relative to the ready-to-use gum solution, unless otherwise indicated. A gum solution may be normally supplied as a concentrated solution which is diluted by the end user with water to a ready-to-use gum solution before use according to the instructions of the supplier, usually 1 part of the gum is diluted with 1 part to 10 parts of water.

Preferred polymers for use as protective compound in the gum solution are gum arabic, pullulan, cellulose derivatives such as carboxymethylcellulose, carboxyethylcellulose or methylcellulose, (cyclo)dextrin or a patotoe dextrine (e.g. Tackidex DF165 dextrine, Avidex 37 LAC19 dextrine), poly(vinyl alcohol), poly(vinyl pyrrolidone), polysaccharide, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Highly preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid or acrylamidopropane sulfonic acid.

Examples of surfactants for use as surface protective agent include anionic or nonionic surfactants. The gum solution may also comprise one or more of the above hydrophilic polymers as surface protective agent and, in addition, one or more surfactants to improve the surface properties of the coated layer. The surface tension of the gum solution is preferably from 20 to 50 mN/m.

The gum solution comprises preferably an anionic surfactant, more preferably an anionic surfactant whereof the anionic group is a sulphonic acid group or a sulphuric acid group or a phosphoric acid group or a phosphorous acid group. Examples of the anionic surfactant include aliphates, abietates, hydroxyalkanesulfonates, alkanesulfonates, alkanesulfates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyoxyethylenealkylphenyl ethers, salts of phosphoric esters of polyoxyethylenealkyl ethers, mono-, di- or tri-styryl-phenol ethoxylate monophosphonic acid having 5 to 60 oxyethylene groups and salts of them (e.g. Dispersing agent LFH, commercially available from Clariant, Soprophor 3D33, Soprophor FL/k and Soprophor 4D360, commercially available from Rhodia, VPQZ 14/100, commercially available from Elementis), and mono-, di- or tri-styryl-phenol ethoxylate sulfate ammonium salt having 5 to 60 oxyethylene groups (e.g. Dispersing agent LFES, commercially available from Clariant), partially saponified compounds of styrenemaleic anhydride copolymers, partially saponified compounds of olefin-maleic anhydride copolymers, and naphthalenesulfonateformalin condensates. Particularly preferred among these anionic surfactants are dialkylsulfosuccinates, salts of alkylsulfuric esters and alkylnaphthalenesulfonates.

Specific examples of suitable anionic surfactants include sodium dodecylphenoxybenzene disulfonate, the sodium salt of alkylated naphthalenesulfonate, disodium methylene-dinaphtalene-disulfonate, sodium dodecyl-benzenesulfonate, sulfonated alkyl-diphenyloxide, ammonium or potassium perfluoroalkylsulfonate, sodium octyl sulphate (e.g. Texapon 842) and sodium dioctyl-sulfosuccinate.

Suitable examples of the nonionic surfactants include polyoxyethylene alkyl ethers,
polyoxyethylene alkyl aryl ethers wherein the aryl group may be a phenyl group, a naphthyl group or an aromatic heterocyclic group (e.g. Sapogenat T130, a tri-butyl-phenol-ethoxylate having 13 oxyethylene groups, commercially available from Clariant), polyoxyethylene polystyryl phenyl ethers such as mono-, di- or tri-styryl-phenol ethoxylate having 5 to 60 oxyethylene groups (e.g. Emulsogen TS050, Emulsogen TS100, Emulsogen TS160, Emulsogen TS200, Emulsogen TS290 and Emulsogen TS540, commercially available from Clariant, Soprophor TS/10, Soprophor CY8, Soprophor BSU, Soprophor TS29, Soprophor 796P, commercially available from Rhodia, Agnique DSP-13, Agnique TSP-15 and Agnique TSP-16, commercially available from Cognis, Serdox NSP14, commercially available from Elementis), polyoxyethylene polyoxypropylene alkyl ethers,
polyoxyethylene polyoxypropylene block polymers (e.g. Pluronic 10300, commercially available from BASF),
partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of
polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides.

Particularly preferred among these nonionic surfactants are polyoxyethylene alkylphenyl ethers, polyoxyethylene alkylnaphthyl ethers, polyoxyethylene polystyryl phenyl ethers and poloxyethylene-polyoxypropylene block polymers. Especially, highly preferred are polyoxyethylene tri-styryl phenyl ethers. Further, fluorinic and siliconic anionic and nonionic surfactants may be similarly used.

Two or more of the above surfactants may be used in combination. For example, a combination of two or more different anionic surfactants or a combination of an anionic surfactant and a nonionic surfactant may be preferred. The amount of such a surfactant is not specifically limited but is preferably from 0.01 to 30 wt.%, more preferably from 0.05 to 20 wt.%.

The presence of surfactants in the gum solution may improve the developing of the lithographic printing plate precursor and this may result in an improved sensitivity and shelf-life of the plate precursor. Furthermore, the presence of surfactants may results in an improved clean-out of the substrate and this may result in an improved lithographic performance of the plate.

In accordance with a preferred embodiment of the present invention, a sludge stabilizer may be added to the gum solution to reduce formation of sludge in the processing unit. Especially, at least one of the following surfactants may be selected as sludge stabilizer: polyoxyethylene polyoxypropylene block polymers (e.g. Pluronic 10300, commercially available from BASF),
polyoxyethylene alkyl aryl ethers wherein the aryl group may be a phenyl group, a naphthyl group or an aromatic heterocyclic group (e.g. Sapogenat T130, a tri-butyl-phenol-ethoxylate having 13 oxyethylene groups, commercially available from Clariant), and polyoxyethylene polystyryl phenyl ethers such as mono-, di- or tri-styryl-phenol ethoxylate having 5 to 60 oxyethylene groups (e.g. Emulsogen TS050, Emulsogen TS100, Emulsogen TS160, Emulsogen TS200, Emulsogen TS290 and Emulsogen TS540, commercially available from Clariant, Soprophor TS/10, Soprophor CY8, Soprophor BSU, Soprophor TS29, Soprophor 796P, commercially available from Rhodia, Agnique DSP-13, Agnique TSP-15 and Agnique TSP-16, commercially available from Cognis, Serdox NSP14, commercially available from Elementis), mono-, di- or tri-styryl-phenol ethoxylate monophosphonic acid having 5 to 60 oxyethylene groups and salts of them (e.g. Dispersing agent LFH, commercially available from Clariant, Soprophor 3D33, Soprophor FL/k and Soprophor 4D360, commercially available from Rhodia, VPQZ 14/100, commercially available from Elementis), and mono-, di- or tri-styryl-phenol ethoxylate sulfate ammonium salt having 5 to 60 oxyethylene groups (e.g. Dispersing agent LFES, commercially available from Clariant).
Especially, polyoxyethylene polystyryl phenyl ethers are more preferred, and polyoxyethylene tri-styryl phenyl ethers are most preferred for reducing the formation of sludge.

According to the present invention the gum solution has a pH-value preferably between 3 and 9, more preferably between 4.5 and 8.5, most preferably between 5 and 7. The pH of the gum solution is usually adjusted with a mineral acid, an organic acid or an inorganic salt in an amount of from 0.01 to 15 wt.%, preferably from 0.02 to 10 wt.% ("wt.%" means "% by weight"). Examples of the mineral acids include nitric acid, sulfuric acid, phosphoric acid and metaphosphoric acid. Especially organic acids are used as pH control agents and as desensitizing agents. Examples of the organic acids include carboxylic acids, sulfonic acids, phosphonic acids or salts thereof, e.g. succinates, phosphates, phosphonates, sulfates and sulfonates. Specific examples of the organic acid include citric acid, acetic acid, oxalic acid, malonic acid, p-toluenesulfonic acid, tartaric acid, malic acid, lactic acid, levulinic acid, phytic acid and organic phosphonic acid.

The gum solution may further comprise an inorganic salt. Examples of the inorganic salt include magnesium nitrate, monobasic sodium phosphate, dibasic sodium phosphate, nickel sulfate, sodium hexametaphosphate and sodium tripolyphosphate. An alkali-metal dihydrogen phosphate such as KH₂PO₄ or NaH₂PO₄ is most preferred. Other inorganic salts can be used as corrosion inhibiting agents, e.g. magnesium sulfate or zinc nitrate. The mineral acid, organic acid or inorganic salt may be used singly or in combination with one or more thereof.

The gum solution may comprise preferably a mixture of an anionic surfactant and an inorganic salt. In this mixture the anionic surfactant is preferably an anionic surfactant with a sulphonic acid group, more preferably an alkali-metal salt of a mono- or di-alkyl substituted diphenylether-sulphonic acid, and the inorganic salt is preferably a mono or dibasic phosphate salt, more preferably an alkali-metal dihydrogen phosphate, most preferably KH₂PO₄ or NaH₂PO₄.

In accordance with another embodiment of the present invention, the gum solution comprising a mixture of an anionic surfactant and an inorganic salt has preferably a pH-value between 3 and 9, more preferably between 4 and 8, most preferably between 5 and 7.

Besides the foregoing components, a wetting agent such as ethylene glycol, propylene glycol, triethylene glycol, butylene glycol, hexylene glycol, diethylene glycol, dipropylene glycol, glycerin, trimethylol propane and diglycerin may also be present in the gum solution. The wetting agent may be used singly or in combination with one or more thereof. In general, the foregoing wetting agent is preferably used in an amount of from 1 to 25 wt.%.

Further, a chelate compound may be present in the gum solution. Calcium ion and other impurities contained in the diluting water can have adverse effects on printing and thus cause the contamination of printed matter. This problem can be eliminated by adding a chelate compound to the diluting water. Preferred examples of such a chelate compound include organic phosphonic acids or phosphonoalkanetricarboxylic acids. Specific examples are potassium or sodium salts of ethylenediaminetetraacetic acid, diethylenetriaminepentaacetic acid, triethylenetetraminehexaacetic acid, hydroxyethylethylenediaminetriacetic acid, nitrilotriacetic acid, 1-hydroxyethane-1,1-diphosphonic acid and aminotri(methylenephosphonic acid). Besides these sodium or potassium salts of these chelating agents, organic amine salts are useful. The preferred amount of such a chelating agent to be added is from 0.001 to 5 wt.% relative to the gum solution in diluted form.

Further, an antiseptic and an anti-foaming agent may be present in the gum solution. Examples of such an antiseptic include phenol, derivatives thereof, formalin, imidazole derivatives, sodium dehydroacetate, 4-isothiazoline-3-one derivatives, benzoisothiazoline-3-one, benztriazole derivatives, amidineguanidine derivatives, quaternary ammonium salts, pyridine derivatives, quinoline derivatives, guanidine derivatives, diazine, triazole derivatives, oxazole and oxazine derivatives. The preferred amount of such an antiseptic to be added is such that it can exert a stable effect on bacteria, fungi, yeast or the like. Though depending on the kind of bacteria, fungi and yeast, it is preferably from 0.01 to 4 wt.% relative to the gum solution in diluted form. Further, preferably, two or more antiseptics may be used in combination to exert an aseptic effect on various fungi and bacteria. The anti-foaming agent is preferably a silicone anti-foaming agent. Another preferred antifoaming agent is phenoxypropanol. Among these anti-foaming agents, either an emulsion dispersion type or solubilized type anti-foaming agent may be used. The proper amount of such an anti-foaming agent to be added is from 0.001 to 1.0 wt.% relative to the gum solution in diluted form.

In addition to the foregoing ingredients a radical stabilizing compound may be present in the gum. The proper amount of such radical stabilizing compound to be added is from 0.01 to 5 wt% relative to the gum solution in ready-to-used concentration. Typical radical stabilizers are disclosed in EP-A 04 101 955, filed on 6 May 2004.

Besides the foregoing components, an ink receptivity agent may be present in the gum solution if desired. Examples of such an ink receptivity agent include turpentine oil, xylene, toluene, low heptane, solvent naphtha, kerosine, mineral spirit, hydrocarbons such as petroleum fraction having a boiling point of about 120°C to about 250°C, diester phthalates (e.g., dibutyl phthalate, diheptyl phthalate, di-n-octyl phthalate, di(2-ethylhexyl) phthalate, dinonyl phthalate, didecyl phthalate, dilauryl phthalate, butylbenzyl phthalate), aliphatic dibasic esters (e.g., dioctyl adipate, butylglycol adipate, dioctyl azelate, dibutyl sebacate, di(2-ethylhexyl) sebacate dioctyl sebacate), epoxidated triglycerides (e.g., epoxy soyabean oil), ester phosphates (e.g., tricresyl phosphate, trioctyl phosphate, trischloroethyl phosphate) and plasticizers having a solidification point of 15°C or less and a boiling point of 300°C or more at one atmospheric pressure such as esters of benzoates (e.g., benzyl benzoate). Examples of other solvents which can be used in combination with these solvents include ketones (e.g., cyclohexanone), halogenated hydrocarbons (e.g., ethylene dichloride), ethylene glycol ethers (e.g., ethylene glycol monomethyl ether, ethylene glycol monophenyl ether, ethylene glycol monobutyl ether), aliphatic acids (e.g., caproic acid, enathic acid, caprylic acid, pelargonic acid, capric acid, undecylic acid, lauric acid, tridecylic acid, myristic acid, pentadecylic acid, palmitic acid, heptadecylic acid, stearic acid, nonadecanic acid, arachic acid, behenic acid, lignoceric acid, cerotic acid, heptacosanoic acid, montanic acid, melissic acid, lacceric acid, isovaleric acid) and unsaturated aliphatic acids (e.g., acrylic acid, crotonic acid, isocrotonic acid, undecyclic acid, oleic acid, elaidic acid, cetoleic acid, erucic acid, butecidic acid, sorbic acid, linoleic acid, linolenic acid, arachidonic acid, propiolic acid, stearolic acid, clupanodonic acid, tariric acid, licanic acid). Preferably, it is an aliphatic acid which is liquid at a temperature of 50°C, more preferably has from 5 to 25 carbon atoms, most preferably has from 8 to 21 carbon atoms. The ink receptivity agent may be used singly or in combination with one or more thereof. The ink receptivity agent is preferably used in an amount of from 0.01 to 10 wt.%, more preferably from 0.05 to 5 wt.%. The foregoing ink receptivity agent may be present as an oil-in-water emulsion or may be solubilized with the aid of a solubilizing agent.

The viscosity of the gum solution can be adjusted to a value of preferably 1.0 to 5 mPa.s, more preferably 1.7 to 5 mPa.s, most preferably 2 to 4.5 mPa.s, by adding viscosity increasing compounds, such as poly(ethylene oxide) or polyvinylalcohol, e.g. having a molecular weight between 10⁴ and 10⁷. Such compounds can be present in a concentration of 0.01 to 10 g/l.

A baking gum has a similar composition as described above, with the additional preference towards compounds that do not evaporate at the usual bake temperatures. Baking gum solutions or baking gumming solutions can be aqueous solutions of sodium dodecyl phenoxy benzene disulphonate, alkylated naphthalene sulphonic acid, sulphonated alkyl diphenyl oxide, methylene dinaphtalene sulphonic acid, etc. Other gumming solutions contain a hydrophilic polymer component and an organic acid component. Still other baking gumming solutions contains the potassium salt of the hydroxyethylidene diphosphonic acid. Still other baking gumming solutions contain a sulphosuccinamate compound and phosphoric acid.

The contact angle between the baking gum solution and the plate is preferably lowered by adding at least one surfactant. Preferred surfactants are non-ionic polyglycols and perfluorated aliphatic polyester acrylates.

The viscosity of the baking gum solution is brought at a value of preferably 1.0 to 5 mPa.s, more preferably 1.7 to 5 mPa.s, most preferably 2 to 4.5 mPa.s, by adding at least one viscosity increasing compound. Preferred viscosity increasing compounds are hydrophilic polymer compounds, more preferably polyethylene oxides. Said polyethylene oxides have preferably a molecular weight between 100,000 and 10,000,000, more preferably between 500,000 and 5,000,000. They are preferably used in a concentration of 0.01 to 10 g/l, more preferably of 0.05 to 5 g/l.

In another embodiment the baking gumming solutions comprises (a) water, (b) at least one hydrophilic polymer and (c) at least one component selected from the group consisting of water soluble organic acids comprising at least two acid functions and being selected form the group consisting of a benzene carboxylic acid, a benzene sulphonic acid, a benzene phosphonic acid, an alkane phosphonic acid and water soluble salts thereof. The mentioned compounds (b) and (c) which are dissolved in the aqueous solution in accordance with the present invention are such that they do not evaporate at the customary baking temperatures. The protective layer which is formed remains water-soluble, even after baking, and can be readily removed without damaging the printing plate.

Component (b) comprises in particular the following hydrophilic polymers : N-polyvinyl-pyrrolidone, polyvinylmethylether, copolymers containing ethylene units and maleic anhydride units, homopolymers or copolymers containing vinyl phosphonic acid units, vinyl methyl phosphinic acid units and/or acrylic acid units and/or a polyalkylene glycol, such as polyethylene glycol.

Component (c) comprises in particular : benzene disulphonic acids, benzene polycarboxylic acids having from 3 to 6 carboxyl groups, alkane diphosphonic acids which having from 1 to 3 carbon atoms in the alkane group, carboxyl group containing alkane diphosphonic acids which have from 5 to 9 carbon atoms in the alkane group, and/or one of the water-soluble salts of these acids (preferably alkali metal salts or ammonium salts). Specific examples of component (c) include benzene-1,3-disulphonic acid, benzene-1,2,4-tricarboxylic acid (trimellitic acid), benzene 1,2,4,5-tetracarboxylic acid (pyromellitic acid), benzene hexacarboxylic adid (mellitic acid), methane diphosphonic acid (diphosphono methane), 4,4-diphosphono-heptane-1,7-dioic acid (3,3-diphosphone-pimeic acid), and the sodium salts of these acids. In other embodiments the baking gumming solution for use can additionally contain hydroxy-polycarboxylic acids, such as citric acid and/or the salts thereof, water soluble alkanediols having at least 4 carbon atoms, such as hexanediol-(1,6) and surfactants (preferably anionic or non-ionic surfactants) such as alkyl aryl sulphonates, alkyl phenol ether sulphonates and a natural surfactant (e.g. Saponin). Specific examples of suitable baking gum solutions, ingredients and concentrations thereof, can be found in e.g. EP-A 222 297, EP-A 1 025 992, DE-A 2 626 473 and US 4,786,581.

### The support

A particularly preferred lithographic support is and electrochemically grained and anodized aluminum support. Graining and anodizing of aluminum supports is well known. The acid used for graining can be e.g. nitric acid or sulfuric acid. The acid used for graining preferably comprises hydrogen chloride. Also mixtures of e.g. hydrogen chloride and acetic acid can be used. The relation between electrochemical graining and anodizing parameters such as electrode voltage, nature and concentration of the acid electrolyte or power consumption on the one hand and the obtained lithographic quality in terms of Ra and anodic weight (g/m² of Al₂O₃ formed on the aluminum surface) on the other hand is well known. More details about the relation between various production parameters and Ra or anodic weight can be found in e.g. the article "Management of Change in the Aluminium Printing Industry" by F. R. Mayers, published in the ATB Metallurgie Journal, volume 42 nr. 1-2 (2002) pag. 69.

In the unpublished EP-A 06 110 468 (filed on 2006-02-28) a characterizing method of the surface of a grained and anodized aluminum is disclosed. The parameter 'mean pith depth', calculated according to this characterizing method, correlates with the number and depth of the pits present at the aluminum surface. The mean pith depth of the aluminum surface is preferably less then 2.0 µm, more preferably less then 1.8 µm, most preferably less then 1.5 µm. The standard deviation of the 'mean pith depth' is preferably less then 0.70, more preferably less then 0.50, most preferably less then 0.35.

The anodized aluminum support may be subject to a so-called post-anodic treatment to improve the hydrophilic properties of its surface. For example, the aluminum support may be silicated by treating its surface with a sodium silicate solution. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from ALLIED COLLOIDS.

In a preferred embodiment of the present invention, the anodized aluminum support is not subject to a post-anodic treatment.

The grained and anodized aluminum support may be a sheet-like material such as a plate or it may be a cylindrical element such as a sleeve which can be slid around a print cylinder of a printing press.

The support can also be a metal support such as aluminum or stainless steel. The metal can also be laminated to a plastic layer, e.g. polyester film. Alternative supports for the plate precursor can also be used, such as amorphous metallic alloys (metallic glasses). Such amorphous metallic alloys can be used as such or joined with other non-amorphous metals such as aluminum. Examples of amorphous metallic alloys are described in US5,288,344, US5,368,659, US5,618,359, US5,735,975, US5,250,124, US5,032,196, US6,325,868, and US6,818,078, the disclosures of which are incorporated by reference. The following references describe the science of amorphous metals in much more detail and are incorporated as references: Introduction to the Theory of Amorphous Metals, N.P. Kovalenko et al.(2001); Atomic Ordering in Liquid and Amorphous Metals, S.I. Popel, et al; Physics of Amorphous Metals, N.P. Kovalenko et al (2001). The metal surface can be grained and anodized as described above.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm. More details of preferred embodiments of the base layer can be found in e.g. EP-A 1 025 992.

The coating.

The lithographic printing plate precursor used in the method of this invention comprises a coating on a support. Said coating comprises a photopolymerizable composition. Said coating may be one layer or may contains two or more layers comprising a photopolymerisable composition. Said layer comprising a photopolymerisable composition or said group of two or more layers comprising a photopolymerisable composition are hereinafter also referred to as "photopolymerisable layer" or "photopolymerisable layers". On the photopolymerizable layer, the coating may further comprise an oxygen-barrier layer, which comprises a water-soluble or water-swellable polymer. Said barrier layer is hereinafter also referred to as "overcoat layer" or "overcoat" or "toplayer". The coating may further comprise an intermediate layer between the photopolymerizable layer and the support. When two or more photopolymerisable layers are present, an intermediate layer is preferably present between the support and that photopolymerisable layer which is nearest to the support.

The thickness of the photopolymerizable layer preferably ranges between 0.4 and 10 g/m², more preferably between 0.5 and 5 g/m², most preferably between 0.6 and 3 g/m².

The photopolymerizable composition typically comprises (i) a polymerizable compound, (ii) a polymerization initiator capable of hardening said polymerizable compound in the exposed areas and (iii) a binder. The photopolymerizable composition may further comprise an adhesion promoting compound.
The polymerizable compound and the polymerization initiator

According to one embodiment of the present invention, said polymerizable composition is a cationic photopolymerisable composition. This means that the polymerizable composition comprises a photopolymerisable compound which is polymerisable monomer or oligomer having at least one epoxy or vinyl ether functional group, hereinafter also referred to as "cationic polymerisable monomer". The polymerization initiator in the cationic photopolymerisable composition may be a Bronsted acid generator capable of generating free acid, optionally in the presence of a sensitizer, upon exposure. Said polymerization initiator is hereinafter also referred to as "cationic photoinitiator" or "cationic initiator".

Suitable cationic polymerisable monomers may be polyfunctional epoxy monomers include, for example, 3,4-epoxycyclohexylmethyl-3,4-epoxycyclohex-ane carboxylate, bis-(3,4 -epoxycyclohexymethyl) adipate, difunctional bisphenol-A epichlorohydrin epoxy resin and multifunctional epichlorohydrinitetraphenylol ethane epoxy resin.

Suitable cationic photoinitiators include, for example, triarylsulfonium hexafluoroantimonate, triarylsulfonium hexafluorophosphate, diaryliodonium hexafluoroantimonate, and haloalkyl substituted s-triazine. It is noted that most cationic initiators are also free radical initiators because, in addition to generating Bronsted acid, they also generate free radicals during photo or thermal decomposition.

According to a preferred embodiment of the present invention, said polymerizable composition is a free-radical photopolymerisable composition. This means that the polymerizable composition comprises a photopolymerisable compound which is polymerisable monomer or oligomer having at least one ethylenically unsaturated double bond, hereinafter also referred to as "free-radical polymerizable monomer" or "polymerisable monomer" or "monomer". Said free-radical polymerisable monomer or oligomer has preferably at least one terminal ethylenically unsaturated double bond. Said free-radical polymerisable monomer or oligomer has preferably 2, 3, 4, 5 or 6 terminal ethylenically unsaturated bonds. The polymerization initiator in the free-radical photopolymerisable composition may be a compound, capable of generating free radical, optionally in the presence of a sensitizer, upon exposure, hereinafter said initiator also referred to as "free radical initiator".

The photopolymerizable composition comprises one or more polymerizable monomer(s) or oligomer(s). Suitable free-radical polymerizable monomers include, for example, multifunctional (meth)acrylate monomers (such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have other double bond or epoxide group, in addition to (meth)acrylate group. The (meth)acrylate monomers may also contain an acidic (such as carboxylic acid) or basic (such as amine) functionality.

Preferred monomers include esters of an unsaturated carboxylic acid (e.g. acrylic acid, methacrylic acid, itaconic acid, crotonic acid, isocrotonic acid, and maleic acid) and an aliphatic polyhydric alcohol compound, such as: ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimediacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy) pheny]dimetliylmethane, and bis[p-(methacryloxyethaxy) phenyl]dimethylmethane, ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate, ethylene glycol dicrotonate, tetramethylene glycol dicrotonate, pentaerythritol dicrotonate, sorbitol tetradicrotonate, ethylene glycol diisocrotonate, pentaerythritol diisocrotonate, and sorbitol tetraisocrotonate, ethylene glycol dimaleate, triethylene glycol dimaleate, pentaerythritol dimaleate and sorbitol tetramaleate.

Other preferred monomers include amides of an unsaturated carboxylic acid and an aliphatic polyhydric amine compound, such as: methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Also preferred monomers include urethane compounds containing two or more ethylenically unsaturated bonds. These polymerizable compounds are reaction products of a polyisocyanate compound, containing two or more isocyanate groups, with a multifunctional alcohol of which the hydroxyl groups are partly or completely esterified with (meth)acrylic acid. Particularly preferred compounds are prepared by reacting hydroxyalkyl(meth)acrylates with diisocyanates, as disclosed in DE 28 22 190 and DE 20 64 079.

Other preferred monomers contain primary, secondary and in particular tertiary amino groups, thio or enol groups, as disclosed in EP 1 349 006 (paragraph [0014] to [0024]). An example of a particularly preferred monomer is:

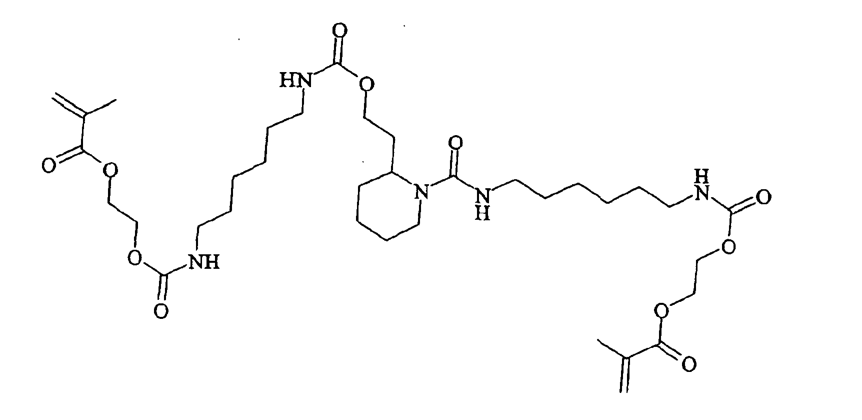

The photopolymerizable composition may also contain polyfunctional (meth)acrylate or alkyl(meth)acrylate compounds as crosslinking agents. Such compounds contain more than 2, preferably between 3 and 6 (meth)acrylate and/or alkyl (meth) acrylate groups and include in particular (meth)acrylates of saturated aliphatic or alicyclic trivalent or polyvalent alcohols such as trimethylol ethane, trimethylol propane, pentaerythritol or dipentaerythritol.

The total amount of polymerizable compounds typically ranges from 10 to 90 percent by weight, preferably from about 20 to 80 percent by weight, relative to the total weight of the non volatile components of the photopolymerizable layer.
Any free-radical initiator capable of generating free radical directly or in the presence of a sensitizer upon exposure can be used as a free-radical initiator of this invention. Suitable free-radical initiators include: aromatic ketones, aromatic onium salts, organic peroxides, thio compounds, hexaarylbisimidazole compounds, ketooxime ester compounds, borate compounds, azinium compounds, metallocene compounds, active ester compounds and compounds having a carbon-halogen bond. Many specific examples of such compounds are found in EP-A 1 091 247 (paragraph [0068] to [0095]), W02005/111 717 (page 16 to page 31) and EP-A 1 491 536 (paragraph [0046] to paragraph [0080].

Preferred initiators are hexaarylbisimidazole compounds, titanocene compounds, trihalomethyl compounds and onium salts. Most preferred initiators are titanocene and hexarylbisimadazole compounds. Preferred titanocene compounds are described in EP-A 1 491 536 (paragraph [66] and [67]).

Particularly preferred initiators are hexaarylbisimidazole (HABI) compounds. Preparation methods of these compounds are described in DE 1 470 154 and their use in photopolymerizable compositions is described in EP 24 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole.

A mixture of two or more different initiators described above may be used in the present invention.

A very high sensitivity can be obtained in the context of the present invention by the combination of an optical brightener as sensitizer and a hexaarylbisimidazole as photoinitiator.

Other suitable free-radical initiators are: derivatives of acetophenone (such as 2,2-dimethoxy-2-phenylacetophenone, and 2-methyl-1-[4-(methylthio) phenyll-2-morpholino propan-1-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-1-yl)-s-triazine, 2,4-bis(trichloromethyl)-6-piperonyl-s-triazine, and 2,4-bis(trichloromethyl)-6-[(4 -ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(1H-pyrrol-1-yl)phenyl) titanium).

The amount of the initiator typically ranges from 0.01 to 30 percent by weight, preferably from 0.5 to 20 percent by weight, relative to the total weight of the non volatile components of the photo-polymerizable layer.

The photopolymerisable composition in the present invention may be also a combination of a free-radical photopolymerisable composition and a cationic photopolymerisable composition. This means that a mixture of the components of both photopolymerisable compositions are present in one photopolymerisable layer of the coating. When two or more phopolymerisble layers are present in the coating, at least one of the layers may comprise a free-radical photopolymerisable composition and at least one of the other layers may comprise a cationic photopolymerisable composition.

The polymerizable monomer or oligomer in such combined photopolymerisable compositions may be a combination of a monomer or oligomer comprising at least one epoxy or vinyl ether functional group and a polymerizable ethylenically unsaturated compound, having at least one terminal ethylenic group, and said initiator may be a combination of a cationic initiator and a free-radical initiator. A monomer or oligomer comprising at least one epoxy or vinyl ether functional group and a polymerizable ethylenically unsaturated compound, having at least one terminal ethylenic group, can be the same compound wherein the compound contains both ethylenic group and epoxy or vinyl ether group. Examples of such compounds include epoxy functional acrylic monomers, such as glycidyl acrylate. The free radical initiator and the cationic initiator can be the same compound if the compound is capable of generating both free radical and free acid. Examples of such compounds include various onium salts such as diaryliodonium hexafluoroantimonate and s-triazines such as 2,4-bis(trichloromethyl)-6-[(4-ethoxyethylenoxy)-phen-1-yl]-s-triazine which are capable of generating both free radical and free acid in the presence of a sensitizer.

The photopolymerizable composition may also comprise a multifunctional monomer. This monomer contains at least two functional groups selected from an ethylenically unsaturated group and/or an epoxy or vinyl ether group. Particular multifunctional monomers for use in the photopolymer coating are disclosed in US 6,410,205 , US 5,049,479, EP 1079276, EP 1369232 , EP 1369231 EP 1341040 , US 2003/0124460, EP 1241002, EP 1288720 and in the reference book including the cited refences : Chemistry & Technology UV & EB formulation for coatings, inks & paints - Volume 2 - Prepolymers and Reactive Diluents for UV and EB Curable Formulations by N.S. Allen, M.A. Johnson, P.K.T. Oldring, M.S. Salim - Edited by P.K.T. Oldring - 1991 - ISBN 0 947798102. Particularly preferred are urethane (meth)acrylate multifunctional monomers, which can be used alone or in combination with other (meth)acrylate multifunctional monomers.

The photopolymerizable composition may also comprise a co-initiator. Typically, a co-initiator is used in combination with a free radical initiator and/or cationic initiator.

Particular co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole or 2-mercapto-benzimidazole.

Other preferred co-initiators are polythioles as disclosed in WO2006/048443 and WO2006/048445. These polythioles may be used in combination with the above described thiols, e.g. 2-mercaptobenzthialole.

Other co-initiators are the co-initiators as disclosed in US 6,410,205, US 5,049,479, EP 1079276, EP 1369232, EP 1369231, EP 1341040, US 2003/0124460, EP 1241002, EP 1288720 and in the reference book including the cited references : Chemistry & Technology UV & EB formulation for coatings, inks & paints - Volume 3 -Photoinitiators for Free Radical and Cationic Polymerisation by K.K. Dietliker - Edited by P.K.T. Oldring - 1991 - ISBN 0 947798161.

The amount of co-initiator generally ranges from 0.01 to 10 % by weight, preferably from 0.1 to 2 % by weight relative to the total weight of the non volatile components of the photopolymerizable composition.

### The sensitizer

The photopolymerisable composition may also comprise a sensitizer. Highly preferred sensitizers are violet light absorbing sensitizers, having an absorption spectrum between 350 nm and 450 nm, preferably between 370 nm and 420 nm, more preferably between 390 nm and 415 nm. Particular preferred sensitizers are disclosed in EP 1 349 006 paragraph [0007] to [0009], EP-A-3103499, filed on 22/09/2003, and WO2004/047930, including the cited references in these patent applications. Other highly preferred sensitizers are infrared light absorbing dyes, having an absorption spectrum between 750 nm and 1300 nm, preferably between 780 nm and 1200 nm, more preferably between 800 nm and 1100 nm. Particular preferred sensitizers are heptamethinecyane dyes, specially the dyes disclosed in EP 1 359 008 paragraph [0030] to [0032]. Other preferred sensitizers are blue, green or red light absorbing sensitizers, having an absorption spectrum between 450 nm and 750 nm. Useful sensitizers can be selected from the sensitizing dyes disclosed in US 6,410,205, US 5,049,479, EP 1 079 276, EP 1 369 232, EP 1 369 231, EP 1 341 040, US 2003/0124460, EP 1 241 002 and EP 1 288 720.

### The binder

The binder of the photopolymerizable layer may be selected from a wide series of organic polymers or co-polymers. Also a mixture of two or more different polymers or co-polymers may be used.

Suitable polymers to be used as binder may include (meth)acrylic resins, polyvinyl acetal resins, polyurethane resins, polyamide resins, epoxy resins, polystyrene resins and polyester resins.

Preferred polymers or co-polymers usable as binder are disclosed in WO2005/111727 (page 17 ln.21 to page 20 ln.3) and WO2005/029187 (page 16 ln.26 to page 18 ln.11).

Preferred binders contain an acid group such as a carboxyl group, a sulfone group or a phosphate group. Particularly preferred and well known are polymers or co-polymers containing carboxyl groups, in particular polymers or co-polymers containing monomeric units of α,β-unsaturated carboxylic acids and/or monomeric units of α,β-unsaturated dicarboxylic acids. Specific examples are polymers or co-polymers of acrylic acid, methacrylic acid, crotonic acid, vinylacetic acid, maleic acid or itaconic acid. Preferred binders have an acid number, expressed as mg KOH/g polymer, of from 10 to 250, preferably from 20 to 200.

Other preferred binders are (meth)acrylic acid ester copolymers, such as a co-polymer of a (meth)acrylic acid alkyl or aralkyl ester with a (meth)acrylic acid ester containing a -CH₂-CH₂-O- or -CH₂-CH₂-NH- unit in R of the ester residue (-COOR) of the (meth)acrylic ester. The alkyl group in the (meth)acrylic acid alkyl ester is preferably an alkyl group having from 1 to 5 carbon atoms, more preferably a methyl group. Preferred examples of the (meth)acrylic acod aralkyl ester include benzyl(meth)acrylate.

The binder preferably comprises hydrophilic groups, e.g. a hydroxyl group, a carboxylate group, a hydroxyethyl group, an ethyleneoxy group, an aminopropyl group, an ammonium group, an amido group or a carbomethyl group.

A hydrophilic polymer may be added to the photopolymerizable layer to enhance the developability. Suitable examples of the hydrophilic polymer include those having a hydrophilic group such as a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonic acid group and a phosphoric acid group. Specific examples thereof include gum arabic, casein, gelatin, starch derivatives, carboxymethylcellulose and sodium salts thereof, cellulose acetate, sodium alignate, cinul acetate-maleic acid co-polymers, tyrene-maleic acid co-polymers, polyacrylic acids and salts thereof, poly(meth)acrylic acids and salts thereof, homopolymers and co-polymers of hydroxyethyl(meth)acrylate, homopolymers and co-polymers of hydroxypropyl(meth)acrylate, homopolymers and co-polymers of hydroxybutyl(meth)acrylate, polyethylene glycols, hydroxypropylene polymers, polyvinyl alcohols, hydrolyzed polyvinyl acetates, polyvinyl formal, polyvinyl butyral, polyvinyl pyrrolidone, homopolymers and polymers of (meth) acrylamide. The hydrophilic polymer preferably has a weight average molecular weight of 5 000 or more, more preferably from 10 000 to 300 000. The hydrophilic polymer may be a random polymer, a block polymer or a graft polymer. The content of the hydrophilic polymer in the image-recording layer is preferably 20 percent by weight or less, more preferably 10 percent by weight or less, relative to the entire solid content of the image-recording layer.

Particularly preferred hydrophilic binders are those disclosed in the unpublished EP-A 06 120 509 wherein the hydrophilic binder is a polymer having at least 1 mol percent of a monomeric unit capable of interacting with the support and at least 30 mol percent of a hydrophilic monomeric unit. In EP-A 06 120 509 the hydrophilic binder is used in combination with a non-polymeric adhesion promoting compound, said compound comprising a group capable of interacting with the aluminum surface. The hydrophilic polymer and the adhesion promoting compound may also be incorporated in an intermediate layer, positioned between the support and the image-recording layer.

Particular suitable binders are copolymers of vinylacetate and vinylalcohol, preferably comprising vinylalcohol in an amount of 10 to 98 mol% vinylalcohol, more preferably between 35 and 95 mol %, most preferably 40 and 75 mol %, best results are obtained with 50 to 65 mol % vinylalcohol. The ester-value, measured by the method as defined in DIN 53 401, of the copolymers of vinylacetate and vinylalcohol ranges preferably between 25 and 700 mg KOH/g, more preferably between 50 and 500 mg KOH/g, most preferably between 100 and 300 mg KOH/g. The viscosity of the copolymers of vinylacetate and vinylalcohol are measured on a 4 weight % aqueous solution at 20°C as defined in DIN 53 015 and the viscosity ranges preferably between 3 and 60 mPa.s, more preferably between 4 and 30 mPa.s, most preferably between 5 and 25 mPa.s. The average molecular weight M_{w} of the copolymers of vinylacetate and vinylalcohol ranges preferably between 5 000 and 500 000 g/mol, more preferably between 10 000 and 400 000 g/mol, most preferably between 15 000 and 250 000 g/mol.

Other particular preferred binders are co-polymers of vinylacetals, vinylacetate and vinylalcohol. These co-polymers may be prepared starting from polyvinylacetates: the polyvinylacetate is first partially hydrolyzed to form a co-polymer of vinylacetate and vinylalcohol, followed by a partially acetylization of the vinylalcohol by reaction with an aldehyde. The most common aldehydes are formaldehyde and butyraldehyde resulting in vinylformal or vinylbutyral, preferably vinylbutyral. The vinylbutyral monomers are hydrophobic while the vinylalcohol and/or vinylacetate monomers are hydrophilic. The hydrophobicity of the binder may influence the ink acceptance and the run length while the hydrophilicity of the binder may influence the developability, especially when development is carried out on press or in a gum solution. By adjusting the ratio vinylbutyral versus vinylalcohol and vinylacetate, the hydrophobicity-hydrophilicity of the binder may be optimized. A partial esterification of the co-polymer with polycarboxylic acids, e.g. trimellit acid, may introduce carboxylic acid groups into the co-polymer to further optimize the hydrophobicity-hydrophilicity of the binder.
The polymer which contains an acid group and the basic nitrogen-containing compound of the photopolymerizable layer

According to a highly preferred embodiment of the present invention, the photopolymerizable layer comprises a polymer which contains an acid group and a basic nitrogen-containing compound capable of neutralizing said acid group or a polymer which contains an acid group which is neutralised with a basic nitrogen-containing compound.

Said basic nitrogen-containing compound preferably has an amino group, an amidine group or a guanidine group. Said amino group is preferably a tertiary amino group. Said amino group may contain an aromatic or heterocyclic group, which may be monocyclic, bicyclic or tricyclic, such as a phenyl group, a benzyl group, a naphtyl group, or a group derived from pyridine, pyrimidine, triazine, oxazine, pyrrole, thiophene, furan, triazole, oxazole, indene, indole, benzofuran, benzoxazole, anthracene, fluorene or carbazole, optionally each of them being substituted. In another preferred embodiment, said basic nitrogen-containing compound further comprises a group having an ethylenically unsaturated bond. Said group having an ethylenically unsaturated bond is most preferably a vinyl group or a (meth)acrylate group.

Examples of basic nitrogen-containing compounds are: N,N-dimethyl amino ethyl (meth)acrylate,
N,N-dimethyl amino propyl (meth)acrylate,
N,N-diethyl amino propyl (meth)acrylate,
N,N-diethyl amino ethyl (meth)acrylate,
N,N-diethyl amino propyl (meth)acrylamide,
N,N-dimethyl amino ethyl-N'-(meth)acryloyl carbamate,
N,N-diethyl amino-ethoxyethyl (meth)acrylate,
t-butyl amino ethyl (meth)acrylate,
N,N-diethyl amino ethanol,
N,N-dimethyl aniline,
N,N-dimethyl amino ethoxy ethanol,
2-amino-2-ethyl-1,3-propanediol,
tetra(hydroxy ethyl) ethylene diamine,
tetramethyl hexane diamine,
tetramethyl butane diamine,
triethanol amine,
triethyl amine,
2-N-morphorino ethanol,
2-piperidino ethanol,
N-methyl amino ethanol,
N,N-dimethyl amino ethanol,
N-ethyl amino ethanol,
N,N,N-buthyl amino diethanol,
N,N-dimethyl amino ethoxy ethanol,
N,N-diethyl amino ethoxy ethanol,
N,ethanol amine,
N,N-diethanol amine,
N,N,N-triethanol amine,
N-methyl diethanol amine,
N,N,N-tri-isopropanol amine,
N,N-dimethyl dihydroxypropyl amine,
N,N-diethyl dihydroxypropyl amine,
N-methyl-glucamine,
Piperazine,
Methylpiperazine,
N-hydroxyethylpiperazine,
N-hydroxyethylpiperazine,
N,N-dihydroxyethylpiperazine or
N-hydroxyethylpiperidine.

Of these nitrogen-containing compounds less volatile compounds are preferred to avoid odor nuisance.

Said polymer which contains an acid group is a polymer which comprises a monomeric unit having in the side chain an acid group. Said acid group is preferably a carboxylic acid group, a sulphonic acid group, an imide group or a primary (i.e. -SO₂-NH₂) or secondary (i.e. -SO₂-NH-) sulphonamide group. Said polymer which contains an acid group is preferably a polymer or copolymer of (meth)acrylic acid, maleic acid, itaconic acid or a (meth)acryl amide.

The basic nitrogen-containing compound may be added previously to the polymer which contains an acid group whereby the acid group is neutralised by the basic nitrogen-containing compound, resulting in the formation of a salt of the acid and the base, and this polymer is added to the solution for coating the photopolymerizable layer. In the salt formation the acid and the base are mainly ionically bond to each other. In an alternative way, the polymer which contains an acid group and the basic nitrogen-containing compound may be both added to the solution for coating the photopolymerizable layer. The ratio of the amount of basic nitrogen-containing compound to the amount of acid groups present in the polymer may vary from 1 to 100 mol %, preferably from 5 to 100 mol %, more preferably from 10 to 100 mol %, most preferably from 20 to 100 %.

In another embodiment, the basic nitrogen-containing compound may be added in excess to the amount of acid groups present in the polymer. In this embodiment, the ratio of the amount of basic nitrogen-containing compound to the amount of acid groups present in the polymer may range between 1 to 200 mol %, preferably between 50 to 200 mol %, more preferably between 100 to 200 mol %, most preferably between 110 to 200 mol %. The presence of an excess of the basic nitrogen-containing compound may improve the developability of the printing plate precursor and may also improve the stability of the pH of the gum solution during processing.

The binder may also comprise a crosslinkable functional group in the main chain or a side chain. A crosslinkable group is capable of crosslinking the polymeric binder upon exposure. The crosslinkable functional group may be an ethylenically unsaturated group, an amino group, an epoxy group, a thiol group, a halogen atom or an onium salt. Preferably, the polymeric binder contains an ethylenically unsaturated group. Examples of suitable crosslinkable binders are discloses in EP 1 748 317 (paragraph [0075] to [0084]). The content of the crosslinkable group (content of radical-polymerizable unsaturated double bond determined by iodine titration) in the binder polymer is preferably from 0.1 to 10.0 mmol, more preferably from 1.0 to 7.0 mmol, and most preferably from 2.0 to 5.5 mmol, per g of binder polymer. The crosslinking property of the binder may increase the durability of the image-areas of the printing plate and therefore improve the run length.

The organic polymers used as binders have a typical mean molecular weight M_{w} between 600 and 200 000, preferably between 1 000 and 100 000.

The amount of binder(s) generally ranges from 10 to 90 % by weight, preferably 20 to 80 % by weight, relative to the total weight of the non-volatile components of the composition.

The total amount of the polymerizable compounds relative to the total amount of binder is preferably from 4.0 to 0.5, more preferably from 2.0 to 1.0.

### The contrast dye

The coating of the lithographic printing plate may further comprise a colorant. The colorant can be a dye or a pigment. After development with a gum solution or with an alkaline developer, at least part of the colorant remains in the hardened coating areas and provides a visible image, enabling an examination of the lithographic image on the developed printing plates. Preferred dyes and/or pigments are disclosed in WO 2005/111727. Highly preferred pigments are predispersed phthalocyanine. Their amount generally ranges from about 1 to 15 % by weight, preferably from about 2 to 7 % by weight, with respect to the total weight of the non-volatile compounds in the photosensitive composition. Particularly suitable predispersed phthalocyanine pigments are disclosed in DE 199 15 717 and DE 199 33 139. Preference is given to metal-free phthalocyanine pigments.

The photopolymerizable composition may also comprise compounds that undergo discoloration or coloration upon exposure with violet light. Compounds that undergo discoloration or coloration by radicals or acids, generated by the violet exposure, are preferred. Especially for the on-press processing embodiment of this invention, such compounds give rise to a print-out image enabling inspection of the image to be printed. Various dyes may be used for this purpose, e.g. diphenylmethane, triphenylmethane, thiazine, oxazine, xanthene, anthraquinone, iminoquinone, azo and azomethine dyes.

### Other ingredients

The photopolymerizable compostion may further comprise other ingredients such as for example surfactants, polymerization inhibitors, plasticizers, inorganic particles, low molecular weight hydrophilic compounds.

Preferred inhibitors for use in the photopolymer coating are disclosed in US 6 410 205, EP 1 288 720 and WO2005/109103.

Various surfactants may be added to the photopolymerizable layer. Both polymeric and small molecule surfactants can be used. Nonionic surfactants are preferred. Preferred nonionic surfactants are polymers and oligomers containing one or more polyether segments (such as polyethylene glycol, polypropylene glycol, and copolymer of ethylene glycol and propylene glycol). Examples of preferred nonionic surfactants are block copolymers of propylene glycol and ethylene glycol (also called block copolymer of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.1 and 30% by weight of the coating, more preferably between 0.5 and 20%, and most preferably between 1 and 15%.

### The overcoat

The coating preferably comprises a top layer, also referred to as overcoat layer, overcoat or protective layer and typically applied onto the image-recording layer, which acts as an oxygen barrier layer.

Preferred binders which can be used in the top layer are disclosed in WO2005/029190 (page 36 line 3 to page 39 line 25), US 2007/0020563 (paragraph [0158]) and EP 1 288 720 (paragraphs [0148] and [0149]). The most preferred binder for the toplayer is polyvinylalcohol. The polyvinylalcohol has preferably a hydrolysis degree ranging between 74 mol % and 99 mol %. The weight average molecular weight of the polyvinylalcohol can be determined by measuring the viscosity of a 4 % by weight aqueous solution at 20 °C, as defined in DIN 53 015. This viscosity number ranges preferably between 3 and 26, more preferably between 3 and 15, most preferably between 3 and 10. Preferably, a mixture of polyvinylalcohols having a different hydrolysis and viscosity number are used.

Modified polyvinylalcohols, e.g. polyvinylalcohols having a carboxyl group and/or a sulphonic acid group may also be used, preferably together with unmodified polyvinylalcohols.

The coating thickness of the top layer is preferably between 0.25 and 1.75 g/m², more preferably between 0.30 and 1.30 g/m², most preferably between 0.40 and 1.00 g/m². In a most preferred embodiment of the present invention, the top layer has a coating thickness between 0.25 and 1.75 g/m² and comprises a polyvinylalcohol having a hydrolysis degree ranging between 74 mol % and 99 mol % and a viscosity number as defined above ranging between 3 and 26.

Besides acting as barrier for oxygen, the overcoat layer must be easily removable during processing and be sufficiently transparent for the actinic radiation, e.g. from 300 to 450 nm or from 700 to 900 nm or from 750 to 1200 nm.

The overcoat layer may comprise other ingredients such as anionic surfactants, e.g. sodium alkyl sulphate or sodium alkyl sulphonate; amphoteric surfactants, e.g. alkylaminocarboxylate and alkylamino-dicarboxylate; non-ionic surfactants, e.g. polyoxyethylene alkyl phenyl ether; the additives, e.g. alkoxylated alkylene diamines, disclosed in EP 1 085 380 (paragraph [0021] and [0022]); glycerine, inorganic particles, pigments, etc.

### The intermediate layer - adhesion promoting compound

The optional intermediate layer may comprise adhesion promoting compounds. These adhesion promoting compounds may however also be incorporated in the photopolymerizable layer. The adhesion promoting compound is preferably a compound capable of interacting with said support, e.g. a compound having an addition polymerizable ethylenically unsaturated bond and a functional group capable of interacting with the support, more preferably a functional group capable of interacting with a grained and anodised aluminum support. Under "interacting" is understood each type of physical and/or chemical reaction or process whereby, between the functional group and the support, a bond is formed which can be a covalent bond, an ionic bond, a complex bond, a coordinate bond or a hydrogen-bridge bond, and which can be formed by an adsorption process, a chemical reaction, an acid-base reaction, a complex-forming reaction or a reaction of a chelating group or a ligand. The adhesion promoting compound may be selected from at least one of the low molecular weight compounds or polymeric compounds as described in EP-A 851 299 from lines 22 on page 3 to line 1 on page 4, EP-A 1 500 498 from paragraph [0023] on page 7 to paragraph [0052] on page 20, EP-A 1 495 866 paragraph [0030] on page 5 to paragraph [0049] on page 11, EP-A 1 091 251 from paragraph [0014] on page 3 to paragraph [0018] on page 20, and EP-A 1 520 694 from paragraph [0023] on page 6 to paragraph [0060] on page 19. Preferred compounds are those compounds which comprise a phosphate or phosphonate group as functional group capable of adsorbing on the aluminum support and which comprise an addition-polymerizable ethylenic double bond reactive group, especially those described in EP-A 851 299 from lines 22 on page 3 to line 1 on page 4 and EP-A 1 500 498 from paragraph [0023] on page 7 to paragraph [0052] on page 20. Also preferred are those compounds comprising tri-alkyl-oxy silane groups, hereinafter also referred to as "trialkoxy silane" groups, wherein the alkyl is preferably methyl or ethyl, or wherein the trialkyloxy silane groups are at least partially hydrolysed to silanol groups, as functional group capable of adsorbing on the support, especially silane coupling agents having an addition-polymerizable ethylenic double bond reactive group as described in EP-A 1 557 262 paragraph [0279] on page 49 and EP-A 1 495 866 paragraph [0030] on page 5 to paragraph [0049] on page 11. The adhesion promoting compound may be present in the photopolymerizable layer in an amount ranging between 1 and 50 % by weight, preferably between 3 and 30 % by weight, more preferably between 5 and 20 % by weight relative to the total amount of the non-volatile components of the composition. The adhesion promoting compound may be present in the intermediate layer in an amount of at least 50 % by weight, preferably at least 80 % by weight, more preferably at least 90 % by weight, most preferably 100 % by weight relative to the total amount of the non-volatile components of the composition. The optionally intermediate layer has a coating thickness preferably ranging between 0.001 and 1.5 g/m², more preferably between 0.003 and 1.0 g/m², most preferably between 0.005 and 0.7 g/m².

### Exposure

The image-wise exposing step is carried out off-press in a plate setter, i.e. an exposure apparatus suitable for image-wise exposing the precursor by a laser such as a laser diode, emitting around 830 nm, a NdYAG laser, emitting around 1060 nm, a violet laser, emitting around 400 nm, or a gas laser such as Ar laser, or by a digital modulated UV-exposure, e.g. by means of digital mirror devices, or by a conventional exposure in contact with a mask.

In a preferred embodiment of the present invention, the precursor is image-wise exposed by a laser emitting IR-light.

In a more preferred embodiment of the present invention, the precursor is image-wise exposed by a laser emitting violet light. This laser emits light having a wavelength of preferably from 300 to 450 nm, more preferably of from 350 to 420 nm and this light preferably has an energy density measured on the surface of the plate of 100 µJ/cm² or less. Preferably laser diodes, highly preferred commercially available InGaN-based semiconductor laser diodes having a wavelength of about 405 nm (+ or - 15 nm), are used to expose the lithographic printing plate precursors. The power of the laser diodes may be between 5 and 200 mW, preferably between 20 mW and 150 mW, most preferably between 50 mW and 80 mW. One laser diode may be used to expose the lithographic printing plate precursors, but also multiple laser diodes may be used.

Three major categories of plate-setters, i.e. apparatuses wherein the lithographic printing plates are image-wise exposed with a laser beam, are known and may be used in the present invention: flat bed, internal drum (ITD) and external drum (XTD) type plate-setters.

A particularly preferred plate-setter, an external drum apparatus emitting one or more scanning laser beams having a wavelength between 390 and 420 nm and an energy density, measured on the surface of the precursor, of 100 µJ/cm² or less, and a method of preparing a printing plate using the plate-setter is disclosed in the unpublished EP-A 06 112 161 (filed 2006-04-03). The pixel dwell time of the scanning laser beam is preferably from 0.5 to 10 microseconds.

Also suitable is the apparatus described in US2006/0001849 comprising an imaging head comprising a plurality of laser diodes emitting light of a wavelength between 350 nm and 450 nm. Since each spot on the lithographic printing plate to be exposed receives light, emitted from a plurality of laser diodes, low power laser diodes can be used.

The method disclosed in WO2005/111717 comprising image-wise exposing a photopolymerizable lithographic printing plate precursor with an imaging time per pixel of 1 milliseconds or less using a laser light with an emission wavelength of from 250 nm to 420 nm may also be used in the present invention.

### Pre-heat

The lithographic printing plate precursors are optionally subjected to a pre-heat step. In such a pre-heat step, performed after image-wise exposure and before development, the plate precursor is heated to enhance or to speed-up the polymerization and/or crosslinking reaction. The pre-heat step may improve the printing properties, e.g. rendition of small dots or run length, of the printing plate. There is no particular time limit between exposure and pre-heat but the pre-heat step is usually carried out within a time period after exposure of less than 10 minutes, preferably less than 5 minutes, more preferably less than 1 minutes, most preferably the pre-heat is carried out immediately after the image-wise exposing, i.e. within less than 30 seconds. In this heating step, the precursor is heated at a temperature of preferably 80°C to 150°C, more preferably of 90 to 140 °C, most preferably of 100 °C to 130 °C during preferably 1 seconds to 1 minute, more preferably 5 seconds to 45 seconds, most preferably 10 seconds to 30 seconds. The pre-heating unit is preferably provided with heating elements such as IR-lamps, UV-lamps, heated air, a heated metal roll, etc.

The pre-heating unit is preferably connected with the development apparatus to enable automatic transport from the pre-heating unit to the development apparatus in a single apparatus. Preferably a cooling section is provided between the pre-heating section and the development section of said single apparatus.

The pre-heating unit, the development unit may also be connected to the plate-setter to enable automatic transport of the exposed precursor to first the pre-heating unit and then the developing unit. Again, a cooling section may be provided between the pre-heating unit and the development unit.

### Development

In accordance with the present invention, the printing plate precursor is developed and gummed in essentially a single step by treating off-press the coating of the precursor with a gum solution comprising a film-forming hydrophilic polymer or surfactant and a salt formed by reaction of an acid, selected from phosphoric acid and phosphorous acid, with a di- or tri-alkanolamine. In this treating step, the gum solution is applied to the precursor, while optionally brushing the precursor, thereby removing the coating at the non-exposed areas from the support and gumming the plate in one single step. Here, the term "in essentially a single step" means that in this developing and gumming step the coating in the non-exposed areas is practically completely removed from the support, but it is not excluded that traces or small amounts of the coating remain on the non-exposed areas and that this remaining coating is further removed on-press with fountain and ink during the start-up of the plate.

In accordance with a preferred embodiment of the present invention, the off-press treating of the coating with the gum solution results in a partial clean-out of the coating at non-exposed areas and wherein the coating at the non-exposed areas is capable of being completely removed on-press. In this treating step, the gum solution is applied to the precursor, while optionally brushing the precursor, thereby removing part of the coating in the non-exposed areas from the support and gumming the plate in one single step. It is important that the coating, remaining on the plate in the non-exposed areas after processing with the gum solution, is capable of being further removed on the press with fountain and ink during the start-up of the printing process. The number of sheets necessary to clean-up these hydrophilic areas is preferably as low as possible, e.g. lower that 25 sheets. It is also important that no toning appears during the printing run after the starting-up procedure.

In this developing and gumming step by treating off-press the the coating with a gum solution, it is important that the coating remaining on the plate in the non-exposed areas after processing with the gum solution is as low as possible in order to obtain an image on the plate with a sufficient contrast whereby the difference in optical density in the exposed and hardened printing areas and in the non-exposed non-printing areas is as much as possible. This contrast has the advantage that the plate and especially the image quality of the plate can be inspected before mounting on the press and starting the printing process. In a preferred embodiment of the present invention, the coating in the non-exposed is as low as possible and is capable of being further removed on the press with fountain and ink during the start-up of the printing process. In a more preferred embodiment of the present invention, the coating in the non-exposed is completely removed by applying a gum solution, while optionally brushing the precursor.

The gum solution in the processing and gumming step can be performed at room temperature or at elevated temperatures, e.g. between 25 and 50 °C. The processing and gumming can be carried on until the gum solution is exhausted and has to be replaced by a fresh gum solution or the gum solution is constantly regenerated by adding fresh gum solution as a function of the amount of printing plate precursors developed. The gum solution, used for regeneration, can be of the same or different, preferably higher, concentration. In the method of making a printing plate according to the present invention, the processing and gumming step may comprise a prewash step as disclosed in the unpublished EP-A 05 110 915 (filed on 2005-11-18). In this method development comprises washing the precursor in a prewashing station by applying water or an aqueous solution to the coating, thereby removing at least part of the toplayer, followed by development of the precursor in a gumming station by applying a gum solution to the coating of the precursor, thereby removing the non-exposed areas of the photopolymerizable layer from the support and gumming the plate in a single step. The development step of this invention may also comprise two gumming steps as disclosed in the unpublished EP-A 05 110 916 and EP-A 05 110 919 (both filed on 2005-11-19). EP-A 05 110 916 describes a development carried out in a gumming station, said gumming station comprises a first and at least a second gumming unit, wherein the precursor is washed in the first gumming unit by applying a gum solution to the coating, thereby removing at least part of the top layer, and wherein, subsequently, the precursor is developed in the second gumming unit with a gum solution, thereby removing non-exposed areas of the photo-polymerizable layer from the support and gumming the plate in a single step. EP-A 05 110 919 describes a development carried out in a gumming station, comprising a first and at least a second gumming unit, wherein the precursor is consecutively developed in said first and said second gumming unit with a gum solution, thereby removing non-exposed areas of the photopolymerizable layer from the support and gumming the plate in a single step.

After the developing and gumming step, the plate can be dried. Optionally, when a baking gum is used in the developing and gumming step as defined above, the plate can be baked.

### EXAMPLES

### Preparation of aluminum support S-1:

A 0.3 mm thick aluminum foil was degreased by spraying with an aqueous solution containing 26 g/l of NaOH at 65°C for 2 seconds and rinsed with demineralized water for 1.5 seconds. The foil was then electrochemically grained during 10 seconds using an alternating current in an aqueous solution containing 15 g/l of HCl, 15 g/l of SO₄²⁻ ions and 5 g/l of Al³⁺ ions at a temperature of 37°C and a current density of about 100 A/dm². The aluminum foil was then desmutted by etching with an aqueous solution containing 5.5 g/l of NaOH at 36°C for 2 seconds and rinsed with demineralized water for 2 seconds. The foil was subsequently subjected to anodic oxidation during 15 seconds in an aqueous solution containing 145 g/l of sulfuric acid at a temperature of 50°C and a current density of 17 A/dm², then washed with demineralized water for 11 seconds and dried aL 120°C for 5 seconds.

The support thus obtained was characterized by a surface roughness Ra of 0.35-0.4 µm, measured with interferometer NT1100, and had an anodic weight of 3.0 g/m².

### Preparation of photosensitive layer P-1:

The coating composition for the photosensitive layer P-1 was prepared by mixing the ingredients as specified in Table 1. The resulting solution was coated with a bar-coater on the support S-1. After coating, the plate was dried for 1 minute at 120°C in a circulation oven. The coating has a dry coating weight of 1.2 g/m²

**Table 1: Composition of the coating solution of P-1.**

| Ingredients | P-1 |
|---|---|
| (in g) | |
| Dowanol PM (11) | 528.39 |
| Polymer-1 (1) | 79.02 |
| DMAP-Mam (2) | 3.96 |
| FST426R (3) | 9.52 |
| Mono Z1620 (4) | 101.32 |
| Heliogene blue (5) | 69.96 |
| Sensi-1 (6) | 3.66 |
| Hostanox 03 (7) | 0.34 |
| HABI (8) | 4.42 |
| MBT (9) | 0.20 |
| Edaplan (10) | 0.68 |
| 2-butanone | 215.25 |

| | |
|---|---|
| (1) Polymer-1 is an esterified copolymer of [vinyl butyral/vinyl alcohol/vinyl acetate], having 64 mol% vinyl butyral, 26 mol% vinyl alcohol, 2 mol% vinyl acetate and 8 mol% trimellit acid ester. (2) DMAP-Mam is N,N dimethylaminopropylmethacrylamide (3) FST426R is a solution in 2-butanone containing 88.2 wt.% of a reaction product from 1 mole of 2,2,4-trimethyl-hexamethylenediisocyanate and 2 moles of hydroxyethylmethacrylate (viscosity 3.30 mm²/s at 25°C). (4) Mono Z1620 is a solution in 2-butanone containing 30.1 wt % of a reaction product from 1 mole of hexamethylenediisocyanate, 1 mole of 2-hydroxyethylmethacrylate and 0.5 mole of 2-(2-hydroxyethyl-piperidine (viscosity 1.7 mm² at 25 °C). (5) Heliogene blue is a Heliogene Blue D 7490 disperson (9.9 wt %, viscosity 7.0 mm²/s at 25 °C), trade name of BASF AG, as defined in EP 1 072 956. (6) Sensi-1 is 1,4-di[3,5-dimethoxy,4-isobuthoxy-styryl]benzene. (7) Hostanox 03 is a phenolic antioxidant from Clariant. (8) HABI is 2,2'-bis(2-chlorophenyl) -4,4',5,5'-tetraphenyl-1,2-bisimidazole. (9) MBT is 2-mercaptobenzothiazole. (10) Edaplan LA 411® is a surfactant, obtained from Münzing Chemie, used as a 1 wt.% in Dowanol PM. (11) Dowanol PM is propyleneglycol monomethylether, commercially available from DOW Chemical Company. | |

### Preparation of overcoat layer OC-1:

On top of the photosensitive layer P-1 a solution in water with the composition as defined in Table 2 was coated and was dried at 110°C for 2 minutes. The so-formed protective overcoat OC-1 has a dry coating weight of 1.8 g/m².

**Table 2: Composition of the coating solution of OC-1.**

| COMPONENTS (in g) | OC-1 |
|---|---|
| partially hydrolyzed polyvinylalcohol (degree of hydrolysis 88 %, viscosity 4 mPa•s in a solution of 4 wt.% at 20 °C) | 17.04 |
| partially hydrolyzed polyvinylalcohol (degree of hydrolysis 88 %, viscosity 8 mPa•s in a solution of 4 wt.% at 20 °C) | 7.43 |
| fully hydrolyzed polyvinylalcohol (degree of hydrolysis 98 %, viscosity 6 mPa•s in a solution of 4 wt.% at 20 °C) | 14.87 |
| Acticide LA1206 (1) | 0.08 |
| Lupasol P (2) | 0.40 |
| Lutensol A8 (90%) (3) | 0.38 |
| Water | 959.80 |

| | |
|---|---|
| (1) Acticide LA1206 is a biocide, commercially available from Thor. (2) Lupasol P is a solution of 50 % by weight in water of a polyethylene imine, commercially available from BASF. (3) Lutensol A8 (90% by weight) is a surface active agent, commercially available from BASF. | |

### Preparation of the printing plate

After drying of the overcoat layer, the precursor was cut in several pieces of 5.5 x 12.5 cm and each piece of the non-exposed precursor was processed in 50 g of a gum solution, having a composition as defined in the Tables 3, 5, 7, 9 and 11, at room temperature by wiping the piece with a cotton pad over a period of 45 s. After flushing with water the clean-out of the plate was tested by treating the plate with a black protection Ink OZASOL RC43, commercially available from Agfa. This test is a measure for the clean-out performance of the plate and an insufficient clean-out is obtained when the plate has a black colour after this ink-treatment indicated by the code "black". This means that the photosensitive coating was insufficiently removed from the hydrophilic surface of the support by the gum solution and exhibits a high tendency of ink-accepting. The code "clean" in this test means that the plate does not accept ink in this ink-treatment test and this indicates that after the processing the plate exhibits an improved clean-out. This means that the coating is sufficiently removed in such a way that the hydrophilic property of the surface of the support reveals at a sufficiently high level that the ink has no tendency to adhere to the plate. The test as described above is a very critical test in order to predict toning or no toning on the press. The test results are in good correlation with the performance of the plate on the press.

The results are summarised in the Tables 4, 6, 8, 10 and 12.

**Table 3: Composition of the gum solutions GUM-01 to GUM-06**

| INGREDIENTS (in g) | GUM-01 | GUM-02 | GUM-03 | GUM-04 | GUM-05 | GUM-06 |
|---|---|---|---|---|---|---|
| PE9400 (1) | 20.00 | 20.00 | 20.00 | 20.00 | 20.00 | 20.00 |
| Emul (2) | 0.30 | 0.30 | 0.30 | 0.30 | 0.30 | 0.30 |
| Glue (3) | 0.75 | 0.75 | 0.75 | 0.75 | 0.75 | 0.75 |
| PA (4) | 5.88 | 5.88 | 5.88 | 5.88 | 5.88 | 5.88 |
| Amine-01 (5) | 14.50 | 23.56 | 88.19 | | | |
| KOH (6) | | | | 5.30 | 6.40 | 6.59 |
| Water | 73.07 | 73.07 | 73.07 | 73.07 | 73.07 | 73.07 |
| pH at 21.4°C | 7.04 | 8.03 | 8.89 | 6.96 | 8.01 | 8.96 |

| | | | | | | |
|---|---|---|---|---|---|---|
| (1)PE9400 represents Pluronic PE9400, a blockcopolymer of ethyleneoxyde and propyleneoxyde having an etyleneoxyde content of 40 % with a molar mass of about 4600, commercially available from BASF. (2)Emul represents Emulsogen TS160, a 2,4,6-tris-(1-phenylethyl)-phenol-ethoxylate (wherein the polyglycolether coimprises approximately 16 ethyleneoxyde units), commercially available from CLARIANT. (3) Gluc represents sodium gluconate. (4)PA represents a solution of phosphoric acid in a concentration of 85 % by weight in water. (5)Amine-01 represents triethanolamine, here used as a solution of 99 % by weight in water. (6) KOH represents a solution of potassium hydroxide in a concentration of 84 % by weight in water. | | | | | | |

**Table 4: Results of clean-out test for GUM-01 to GUM-06.**

| EXAMPLE | GUM-solution | Clean-out test |
|---|---|---|
| Invention Example 1 | GUM-01 | clean |
| Invention Example 2 | GUM-02 | Clean |
| Invention Example 3 | GUM-03 | clean |
| Comparative Example 1 | GUM-04 | black |
| Comparative Example 2 | GUM-05 | black |
| Comparative Example 3 | GUM-06 | black |

The Invention Examples 1 to 3 demonstrate an improved clean-out performance for the gum solutions comprising a phosphoric acid salt of triethanolamine, in comparison to the Comparative Examples 1 to 3 wherein the gum solution comprises a phosphoric acid salt of potassium hydroxide.

**Table 5: Composition of the gum solutions GUM-07 to GUM-10**

| INGREDIENTS (in g) | GUM-07 | GUM-08 | GUM-09 | GUM-10 |
|---|---|---|---|---|
| PE10300 (7) | 2.50 | 2.50 | 2.50 | 2.50 |
| Texa (8) | 5.95 | 5.95 | 5.95 | 5.95 |
| Amine-01 (5) | 5.84 | 5.84 | 5.84 | 5.84 |
| PA (4) | 2.35 | | | |
| SA (9) | | 1.84 | | |
| NA (10) | | | 3.36 | |
| HA (11) | | | | 3.42 |
| Water | 83.35 | 83.86 | 82.34 | 82.29 |
| pH at 21.4°C | 7.08 | 6.88 | 7.12 | 7.05 |

| | | | | |
|---|---|---|---|---|
| (4) and (5) see Table 3 (7) PE10300 represents Pluronic PE10300, a blockcopolymer of ethyleneoxyde and propyleneoxyde having an ethyleneoxyde content of 30 % with a molar mass of about 4950, commercially available from BASF. (8)Texa represents TEXAPON 842™, a solution of sodium octylsulphate of 42 % by weight in water, commercially available from COGNIS. (9)SA represents sulphuric acid, here used as a solution of 96 % by weight in water. (10) NA represents nitric acid, here used as a solution of 65 % by weight in water. (11) HA represents hydrochloric acid, here used as a solution of 37 % by weight in water. | | | | |

**Table 6: Results of clean-out test for GUM-07 to GUM-10**

| EXAMPLE | GUM-solution | Clean-out test |
|---|---|---|
| Invention Example 4 | GUM-07 | clean |
| Comparative Example 4 | GUM-08 | black |
| Comparative Example 5 | GUM-09 | black |
| Comparative Example 6 | GUM-10 | black |

The Invention Example 4 demonstrates an improved clean-out performance for the gum solutions comprising a triethanolamine salt of phosphoric acid, in comparison to the Comparative Examples 4 to 6 wherein the gum solution comprises triethanolamine salts of other inorganic acids than phosphoric acid.

**Table 7: Composition of the gum solutions GUM-11 to GUM-16**

| INGREDIENTS (in g) | GUM-11 | GUM-12 | GUM-13 | GUM-14 | GUM-15 | GUM-16 |
|---|---|---|---|---|---|---|
| PE10300 (7) | 2.50 | 2.50 | 2.50 | 2.50 | 2.50 | 2.50 |
| Texa (8) | 5.95 | 5.95 | 5.95 | 5.95 | 5.95 | 5.95 |
| Amine-01 (5) | 5.84 | 5.84 | 5.84 | 5.84 | 5.84 | 5.84 |
| FA (12) | 1.65 | | | | | |
| AA (13) | | 2.16 | | | | |
| BA (14) | | | 4.05 | | | |
| TA (15) | | | | 2.73 | | |
| CA (16) | | | | | 2.35 | |
| PTSA (17) | | | | | | 7.05 |
| Water | 84.06 | 83.54 | 81.65 | 82.97 | 83.35 | 78.65 |
| pH at 21.4°C | 6.97 | 7.05 | 7.06 | 7.00 | 7.05 | 7.02 |

| | | | | | | |
|---|---|---|---|---|---|---|
| (5) and (7) and (8) see Table 5. (12) FA represents formic acid, here used as a solution of 99 % by weight in water. (13) AA represents acetic acid. (14) BA represents benzoic acid. (15) TA represents tartaric acid. (16) CA represents citric acid. (17) PTSA represents para-toluene sulphonic acid, here used as a hydrate. | | | | | | |

**Table 8: Results of clean-out test for GUM-11 to GUM-16**

| EXAMPLE | GUM-solution | Clean-out test |
|---|---|---|
| Comparative Example 7 | GUM-11 | black |
| Comparative Example 8 | GUM-12 | black |
| Comparative Example 9 | GUM-13 | black |
| Comparative Example 10 | GUM-14 | black |
| Comparative Example 11 | GUM-15 | black |
| Comparative Example 12 | GUM-16 | black |

The Comparative Examples 7 to 12 demonstrates an insufficient clean-out performance for the gum solutions comprising a triethanolamine salt of an organic acid.

**Table 9: Composition of the gum solutions GUM-11 to GUM-16**

| INGREDIENTS (in g) | GUM-17 | GUM-18 | GUM-19 | GUM-20 | GUM-21 | GUM-22 |
|---|---|---|---|---|---|---|
| PE10300 (7) | 2.50 | 2.50 | 2.50 | 2.50 | 2.50 | 2.50 |
| Texa (8) | 5.95 | 5.95 | 5.95 | 5.95 | 5.95 | 5.95 |
| PA(4) | 2.35 | 2.35 | 2.35 | 2.35 | 2.35 | 2.35 |
| KOH (6) | 2.59 | | | | | |
| NaOH (18) | | 1.58 | | | | |
| C-Amine-01(19) | | | 2.37 | | | |
| Amine-02 | | | | 4.08 | | |
| C-Amine-02(20) | | | | | 3.46 | |
| C-Amine-03(21) | | | | | | 2.94 |
| Water | 86.60 | 87.61 | 86.83 | 85.12 | 78.65 | 86.25 |
| pH at 21.4°C | 8.09 | 7.62 | 7.41 | 7.46 | 7.43 | 7.63 |

| | | | | | | |
|---|---|---|---|---|---|---|
| (4) and (6) see Table 3. (7) and (8) see table 5. (18) NaOH represents sodium hydroxide, here used as a solution of 98 % by weight in water. (19) C-Amine-01 represents aminoethanol having the chemical structure of HO-CH₂-CH₂-NH₂. (20) C-Amine-02 represents N,N-dimethylamino-ethanol having the chemical structure of HO-CH₂-CH₂-N(CH₃)₂. (21) C-Amine-03 represents 1-amino-2-propanol having the chemical structure of CH₃-CH(OH)-CH₂-NH₂. | | | | | | |

**Table 10: Results of clean-out test for GUM-17 to GUM-22**

| EXAMPLE | GUM-solution | Clean-out test |
|---|---|---|
| Comparative Example 13 | GUM-17 | black |
| Comparative Example 14 | GUM-18 | black |
| Comparative Example 15 | GUM-19 | black |
| Invention Example 5 | GUM-20 | clean |
| Comparative Example 16 | GUM-21 | black |
| Comparative Example 17 | GUM-22 | black |

The Invention Example 5 demonstrates an improved clean-out performance for the gum solution comprising a phosphoric acid salt of diethanolamine, in comparison to the Comparative Examples 13 and 14 wherein the gum solution comprises a phosphoric acid salt of potassium hydroxide or sodium hydroxide and also in comparison to the Comparative Examples 15 to 17 wherein the gum solution comprises a phosphoric acid salt of a mono-alkanolamine.

**Table 11: Composition of the gum solutions GUM-23 to GUM-28**

| INGREDIENTS (in g) | GUM-23 | GUM-24 | GUM-25 | GUM-26 | GUM-27 | GUM-28 |
|---|---|---|---|---|---|---|
| PE10300 (7) | 2.50 | 2.50 | 2.50 | 2.50 | 2.50 | 2.50 |
| Texa (8) | 5.95 | 5.95 | 5.95 | 5.95 | 5.95 | 5.95 |
| PA(4) | 2.35 | 2.35 | 2.35 | 2.35 | 2.35 | 2.35 |
| C-Amine-04(22) | 3.64 | | | | | |
| C-Amine-05(23) | | 5.68 | | | | |
| Amine-03 | | | 4.08 | | | |
| Amine-04 (24) | | | | 5.44 | | |
| Amine-05 | | | | | 4.70 | |
| Amine-06 (25) | | | | | | 7.81 |
| Water | 85.56 | 83.51 | 85.12 | 83.76 | 84.50 | 81.39 |
| pH at 21.4°C | 7.56 | 7.66 | 7.35 | 7.35 | 7.05 | 7.24 |

| | | | | | | |
|---|---|---|---|---|---|---|
| (4) see Table 3. (7) and (8) see Table 5. (22) C-Amine-04 represents 2-amino-2-methyl-1-propanol having the chemical structure of CH₃-C(CH₃)(NH₂)-CH₂-OH. (23) C-Amine-05 represents 2-(N,N-dimethyl)-amino-2-methyl-1-propanol having the structure of CH₃-C[CH₃][N(CH₃)₂]-CH₂-OH. (24) Amine-04 is here used as a solution of 85 % by weight in water. (25) Amine-06 is here used as a solution of 95 % by weight in water. | | | | | | |

**Table 12: Results of clean-out test for GUM-23 to GUM-28**

| EXAMPLE | GUM-solution | Clean-out test |
|---|---|---|
| Comparative Example 18 | GUM-23 | black |
| Comparative Example 19 | GUM-24 | black |
| Invention Example 6 | GUM-25 | clean |
| Invention Example 7 | GUM-26 | clean |
| Invention Example 8 | GUM-27 | clean |
| Invention Example 9 | GUM-28 | clean |

The Invention Examples 6 to 9 demonstrate an improved clean-out performance for the gum solution comprising a phosphoric acid salt of a di- or tri-alkanolamine, in comparison to the Comparative Examples 18 and 19 wherein the gum solution comprises a phosphoric acid salt of a mono-alkanolamine.

### Test experiments on sludge formation

The precursor as prepared above was developed in a small lab processing unit with the gum solution Gum-29 as defined in Table 13. In this experiment 100 g of the Gum-29 solution was saturated by completely washing off 1.5 m² of the precursor.

**Table 13: Composition of the gum solution GUM-29**

| INGREDIENTS (in g) | GUM-29 |
|---|---|
| Texapon 842 (1) | 2.38 |
| PA (2) | 0.30 |
| Dowanol PPh (3) | 0.50 |
| Amine-05 | 0.60 |
| Avedex 37 LAC19 (4) | 2.50 |
| Demineralised water | 93.72 |

| | |
|---|---|
| (1) Texapon 842 represents a solution of sodium octylsulfate in a concentration of 42 % by weight in water, commercially available from Cognis. (2)PA represents a solution of phosphoric acid in a concentration of 85 % by weight in water. (3)Dowanol PPh represents 1-phenoxy-2-propanol (purity ≥ 93 %), commercially available from Dow. (4)Avedex 37 LAC19 represents a potato dextrine, commercially available from Avebe Group, Veendam, NL. | |

To 55 g of this saturated Gum-29 solution a sludge stabilizer as defined in Table 14 was added in different amounts as indicated in Table 14. No sludge stabilizer compound was added in the Reference test of Table 14. Each mixture of the saturated Gum-29 solution with the sludge stabilizer was stirred for 20 h at room temperature and, subsequently, 50 g of each mixture was cenrifugated for 45 minutes using 4000 rpm at 25°C. After separation of the settlement from the solution by decantation, the remaining solid was dried at 110°C for 45 minutes. The sludge is defined as the weight of the remaining solid calculated for 1 kg of saturated Gum-29 solution. The sludge is indicated in Table 14 and a high value indicates an increased tendency of formation of sludge in the processing unit. If the sludge value is lower than the reference, this means that the added sludge stabilizer is efficient in further suppression of sludge formation.

**Table 14: Composition and results of the Sludge formation tests.**

| Type of Sludge Stabilizer | Amount of Sludge Stabilizer added to 55 g saturated Gum-29 solution (in g) | Sludge (in g solid for 1 kg saturated Gum-29 solution |
|---|---|---|
| Reference | - | 6.40 |
| Pluronic 10300 (1) | 0.55 | 4.46 |
| Pluronic 10300 (1) | 1.65 | 4.90 |
| Sapogenat T130 (2) | 0.55 | 5.49 |
| Sapogenat T130 (2) | 1.65 | 4.65 |
| Emulsogen TS160 (3) | 0.55 | 3.34 |
| Emulsogen TS160 (3) | 1.65 | 2.46 |

| | | |
|---|---|---|
| (1)Pluronic 10300 represents a block copolymer of polyoxypropylene (70% by weight)/polyoxyethylene (30% by weight), having Mw of about 4950, commercially available from BASF. (2) Sapogenat T130 represents a tri-butylphenol-ethoxylate (wherein the polyoxyethyleneoxyde comprises 13 monomeric units), commercially available from Clariant. (3) Emulsogen TS160 represents 2,4,6-tris-(1-phenylethyl)-phenol-ethoxylate (wherein the polyglycolether coimprises approximately 16 ethyleneoxyde units), commercially available from CLARIANT. | | |

The results as indicated in Table 14 show that sludge stabilizers can be added to the gum solution of the present invention in order to further reduce the formation of sludge. Good results are obtained when the following sludge stabilizers are added to a gum solution of the present invention: blockcopolymers of polyoxyethylene/polyoxypropylene and tri-butylphenol-ethoxylates, and especially good results are obtained when tri-styrylphenol-ethoxylates are added.

## Claims

1. A gum solution suitable for developing and gumming a lithographic printing plate precursor comprising a film-forming hydrophilic polymer or surfactant,
**characterized in that** said gum solution further comprises a salt formed by reaction of an acid, selected from phosphoric acid and phosphorous acid, with a di- or tri-alkanolamine.

2. A gum solution according to claim 1, wherein said acid is phosphoric acid.

3. A gum solution according to any of the preceding claims, wherein said di- or tri-alkanolamine is a monovalent amine substituted with two or three alkanol groups.

4. A gum solution according to any of the preceding claims, wherein said alkanol group comprises at most 12 carbon atoms.

5. A gum solution according to any of the preceding claims, wherein said salt is present in the gum solution in a concentration of at least 0.02 mol/l.

6. A gum solution according to any of the preceding claims, wherein the ratio of the amount of equivalent base functions of the amine to the amount of equivalent acid functions of the acid is preferably at least 0.03.

7. A gum solution according to any of the preceding claims, further comprising at least one sludge stabilizer, selected from a blockcopolymer of polyoxyethylene/polyoxypropylene, a polyoxyethylene alkyl aryl ether and a polyoxyethylene polystyryl phenyl ether.

8. A gum solution according to claim 7, wherein said sludge stabilizer is a polyoxyethylene tri-styryl phenyl ether.

9. A method of preparing a lithographic printing plate comprising the steps of:
a) providing a lithographic printing plate precursor comprising
- a support having a hydrophilic surface or which is provided with a hydrophilic layer, and
- a coating provided thereon, said coating comprising a photopolymerizable composition,
b) image-wise exposing said precursor,
c) optionally, heating the precursor,
d) developing and gumming the precursor in essentially a single step by treating off-press the coating of the precursor with a gum solution according to one of the preceding claims 1 to 8.

10. A method according to claim 9, wherein the off-press treating of the coating with the gum solution in step d) results in a partial clean-out of the coating at non-exposed areas and wherein the coating at the non-exposed areas is capable of being completely removed on-press.

11. A method according to claim 9 or 10, wherein said precursor is image-wise exposed in step b) with light having a wavelength of 350 to 450 nm.

12. A method according to claim 9, 10 or 11, wherein said photopolymerizable composition comprises
- a polymer having a monomeric unit containing an acid group and a basic nitrogen-containing compound capable of neutralizing said acid group, or
- a polymer having a monomeric unit containing an acid group which is neutralized by a basic nitrogen-containing compound.

## Patentansprüche

1. Eine für die Entwicklung und Gummierung einer lithografischen Druckplattenvorstufe geeignete Gummierlösung, die ein filmbildendes hydrophiles Polymer oder Tensid enthält,
**dadurch gekennzeichnet, dass** die Gummierlösung ferner ein durch Reaktion einer aus der Gruppe bestehend aus einer Phosphorsäure und einer phosphorigen Säure gewählten Säure mit einem Di- oder Trialkanolamin gebildetes Salz enthält.

2. Gummierlösung nach Anspruch 1, **dadurch gekennzeichnet, dass** die Säure Phosphorsäure ist.

3. Gummierlösung nach einem der vorstehenden Ansprüche, **dadurch gekennzeichnet, dass** das Di- oder Trialkanolamin ein durch zwei oder drei Alkanolgruppen substituiertes, einwertiges Amin ist.

4. Gummierlösung nach einem der vorstehenden Ansprüche, **dadurch gekennzeichnet, dass** die Alkanolgruppe höchstens 12 Kohlenstoffatome enthält.

5. Gummierlösung nach einem der vorstehenden Ansprüche, **dadurch gekennzeichnet, dass** das Salz in einem Mindestverhältnis von 0,02 Mol/l in der Gummierlösung enthalten ist.

6. Gummierlösung nach einem der vorstehenden Ansprüche, **dadurch gekennzeichnet, dass** das Verhältnis der Menge äquivalenter Basefunktionen des Amins zur Menge äquivalenter Säurefunktionen der Säure bevorzugt mindestens 0,03 beträgt.

7. Gummierlösung nach einem der vorstehenden Ansprüche, die ferner mindestens einen Schlammstabilisator, der aus der Gruppe bestehend aus einem Blockcopolymer von Polyoxyethylen und Polyoxypropylen, einem Polyoxyethylenalkylarylether und einem Polyoxyethylenpolystyrylphenylether gewählt wird, enthält.

8. Gummierlösung nach Anspruch 7, **dadurch gekennzeichnet, dass** der Schlammstabilisator ein Polyoxyethylentristyrylphenylether ist.

9. Ein Verfahren zur Herstellung einer lithografischen Druckplatte, das folgende Schritte umfasst:
a) Bereitstellen einer lithografischen Druckplattenvorstufe, umfassend :
- einen Träger mit einer hydrophilen Oberfläche oder einen mit einer hydrophilen Schicht versehenen Träger und
- eine auf den Träger angebrachte Beschichtung, die eine fotopolymerisierbare Zusammensetzung enthält,
b) bildmäßige Belichtung der Vorstufe,
c) gegebenenfalls Erwärmung der Vorstufe,
d) Entwicklung und Gummierung der Vorstufe während im Wesentlichen einem einzelnen Schritt, der darin besteht, die Beschichtung der Vorstufe "off press" mit einer Gummierlösung nach einem der vorstehenden Ansprüche 1 bis 8 zu behandeln.

10. Verfahren nach Anspruch 9, **dadurch gekennzeichnet, dass** die "off press"-Behandlung der Beschichtung mit der Gummierlösung in Schritt d) in einer partiellen Reinigung der unbelichteten Bereiche der Beschichtung resultiert und die unbelichteten Bereiche der Beschichtung "on press" vollständig entfernt werden können.

11. Verfahren nach Anspruch 9 oder 10, **dadurch gekennzeichnet, dass** die Vorstufe in Schritt b) mit Licht mit einer Wellenlänge zwischen 350 und 450 nm bildmäßig belichtet wird.

12. Verfahren nach Anspruch 9, 10 oder 11, **dadurch gekennzeichnet,**
**dass** die fotopolymerisierbare Zusammensetzung folgende Komponenten enthält. :
- ein Polymer mit einer Monomereinheit, die eine Säuregruppe und eine basische stickstoffhaltige Verbindung, welche in der Lage ist, die Säuregruppe zu neutralisieren, enthält, oder
- ein Polymer mit einer Monomereinheit, die eine mit einer basischen stickstoffhaltigen Verbindung neutralisierte Säuregruppe enthält.

## Revendications

1. Une solution de gommage appropriée pour le développement et le gommage d'un précurseur de plaque d'impression lithographique, ladite solution de gommage contenant un polymère ou un agent tensioactif hydrophile filmogène,
**caractérisée en ce que** la solution de gommage contient en outre un sel formé par réaction d'un acide choisi parmi un acide phosphorique et un acide phosphoreux avec une di- ou trialcanolamine.

2. Solution de gommage selon la revendication 1, **caractérisée en ce que** l'acide est l'acide phosphorique.

3. Solution de gommage selon l'une quelconque des revendications précédentes, **caractérisée en ce que** la di- ou trialcanolamine est une amine monovalente substituée par deux ou trois groupes alcanol.

4. Solution de gommage selon l'une quelconque des revendications précédentes, **caractérisée en ce que** le groupe alcanol contient au plus 12 atomes de carbone.

5. Solution de gommage selon l'une quelconque des revendications précédentes, **caractérisée en ce que** le rapport minimal du sel dans la solution de gommage s'élève à 0,02 mole/l.

6. Solution de gommage selon l'une quelconque des revendications précédentes, **caractérisée en ce que** le rapport de la quantité de fonctions basiques équivalentes de l'amine à la quantité de fonctions acides équivalentes de l'acide s'élève de préférence à au moins 0,03.

7. Solution de gommage selon l'une quelconque des revendications précédentes, contenant en outre au moins un stabilisateur de dépôt boueux choisi parmi un copolymère bloc de polyoxyéthylène et de polyoxypropylène, un éther de polyoxyéthylène-alkylaryle et un éther de polyoxyéthylène-polystyrylphényle.

8. Solution de gommage selon la revendication 7, **caractérisée en ce que** le stabilisateur de dépôt boueux est un éther de polyoxyéthylène-tristyrylphényle.

9. Un procédé pour la confection d'une plaque d'impression lithographique, comprenant les étapes ci-après :
a) la mise à disposition d'un précurseur de plaque d'impression lithographique comprenant :
- un support ayant une surface hydrophile ou un support revêtu d'une couche hydrophile et
- un revêtement appliqué sur le support et contenant une composition photopolymérisable,
b) l'exposition sous forme d'image du précurseur,
c) le chauffage éventuel du précurseur,
d) le développement et le gommage du précurseur, essentiellement en une seule étape consistant en un traitement « off press » du revêtement du précurseur avec une solution de gommage selon l'une quelconque des revendications précédentes 1 à 8.

10. Procédé selon la revendication 9, **caractérisé en ce que** le traitement « off press » du revêtement avec la solution de gommage lors de l'étape d) provoque un nettoyage partiel des zones non exposées du revêtement et qu'un traitement « on press » permet une élimination totale des zones non exposées du revêtement.

11. Procédé selon la revendication 9 ou 10, **caractérisé en ce que** l'étape b) consiste à exposer le précurseur sous forme d'image à de la lumière d'une longueur d'onde comprise entre 350 et 450 nm.

12. Procédé selon la revendication 9, 10 ou 11, **caractérisé en ce que** la composition photopolymérisable contient :
- un polymère contenant une unité monomère comprenant un groupe acide et un composé azoté basique capable de neutraliser le groupe acide, ou
- un polymère contenant une unité monomère comprenant un groupe acide neutralisé par un composé azoté basique.
